# EUROPEAN PATENT APPLICATION

(11) **EP 4 517 834 A1**
(43) Date of publication of application: **05.03.2025**
(21) Application number: 22963156.9
(22) Date of filing: 28.10.2022
(51) Int. Cl.: H01L 29/786, H01L 21/336

(54) **THIN FILM TRANSISTOR DEVICE AND MANUFACTURING METHOD THEREFOR, COMPOUND ETCHING SOLUTION, AND ARRAY SUBSTRATE**

(71) Applicant: Boe Technology Group Co., Ltd., Beijing 100015 (CN); Wuhan Boe Optoelectronics Technology Co., Ltd., Wuhan, Hubei 430040 (CN)
(72) Inventor: WU, Zhaojian, Beijing 100176 (CN); ZHANG, Fugang, Beijing 100176 (CN); XU, Yadong, Beijing 100176 (CN); ZHENG, Xiaoqi, Beijing 100176 (CN); XIA, Yingying, Beijing 100176 (CN); ZHANG, Rui, Beijing 100176 (CN); YI, Dingli, Beijing 100176 (CN); ZHANG, Ruihao, Beijing 100176 (CN); YANG, Shengbiao, Beijing 100176 (CN); ZHANG, Yue, Beijing 100176 (CN); SUN, Mengxiang, Beijing 100176 (CN); PENG, Gang, Beijing 100176 (CN); QIAO, Mingdi, Beijing 100176 (CN); YANG, Ziheng, Beijing 100176 (CN); LU, Gao, Beijing 100176 (CN); DAI, Wei, Beijing 100176 (CN); WANG, Zhenyu, Beijing 100176 (CN)
(74) Representative: Maiwald GmbH
(86) International application number: PCT/CN2022/128278
(87) International publication number: WO 2024/087174

(57) **Abstract**

The embodiments of the present disclosure provide a thin film transistor device and a manufacturing method therefor, a compound etching solution, and an array substrate. The method comprises : forming an active structure material layer comprising an active material layer and an ohmic contact material layer, and a source-drain material layer on a base substrate; and subjecting the source-drain material layer and the active structure material layer to a wet etching process by using a composite etching solution, so as to form a source-drain electrode layer and an active structure comprising an ohmic contact layer and an active layer, wherein the wet etching process includes etching the source-drain material layer and oxidizing part of the active structure material layer with a first etching solution of the compound etching solution, and etching the oxidized part of the active structure material layer with a second etching solution of the compound etching solution; and the ohmic contact layer is located in a region overlapping with the source-drain electrode layer in the direction perpendicular to the main surface of the base substrate, and in the direction perpendicular to the main surface of the base substrate, an orthographic projection of the ohmic contact layer on the base substrate is located within an orthographic projection range of the source-drain electrode layer on the base substrate.

## Description

### TECHNICAL FIELD

Embodiments of the present disclosure relate to a thin film transistor device and a manufacturing method thereof, a composite etching solution, and an array substrate.

### BACKGROUND

Array substrates including thin film transistors (TFTs) are widely applied in display devices such as liquid crystal display (LCD), in which the thin film transistor is usually used as a driving element, a switching element or the like.

The thin film transistor generally includes component layers such as a metal layer, a semiconductor layer and an insulating layer, and a manufacturing process of the thin film transistor normally includes multiple etching processes for patterning these layers. As the thin film transistor is an important constituent component of the array substrate, how to increase a production efficiency of these etching processes and improve structural characteristics of the thin film transistor formed by these etching processes have become key factors for improving the production efficiency and device performances of the array substrate.

### SUMMARY

At least one embodiment of the present disclosure provides a method of manufacturing a thin film transistor device, including: forming a gate electrode layer on a base substrate; forming a gate insulating layer on a side of the gate electrode layer; forming an active structure material layer on a side of the gate insulating layer away from the gate electrode layer, wherein the active structure material layer includes an active material layer and an ohmic contact material layer, and the ohmic contact material layer is formed on a side of the active material layer away from the gate insulating layer; forming a source/drain material layer on a side of the active structure material layer away from the gate insulating layer; and performing a wet etching process on the source/drain material layer and the active structure material layer by using a patterned mask layer as an etching mask and using a composite etching solution, so as to pattern the source/drain material layer and the active structure material layer into a source/drain electrode layer and an active structure, wherein the composite etching solution includes a first etching solution and a second etching solution, and the wet etching process includes: etching the source/drain material layer and oxidizing a portion of the active structure material layer through the first etching solution, and etching an oxidized portion of the active structure material layer through the second etching solution, wherein the active structure includes an active layer and an ohmic contact layer, and the active structure has overlapping regions, a channel region and a tailing region, wherein the overlapping regions overlap with the source/drain electrode layer in a direction perpendicular to a main surface of the base substrate, the channel region is located between the overlapping regions, and the tailing region laterally extends beyond an edge of the source/drain electrode layer away from the channel region in a direction parallel to the main surface of the base substrate; wherein the ohmic contact layer is located in the overlapping regions, and in the direction perpendicular to the main surface of the base substrate, an orthographic projection of the ohmic contact layer on the base substrate is located within a range of an orthographic projection of the source/drain electrode layer on the base substrate.

In the method of manufacturing the thin film transistor device according to at least one embodiment of the present disclosure, the overlapping regions of the active structure includes an overlapping part of the active layer, and the ohmic contact layer located between the overlapping part and the source/drain electrode layer; the channel region includes a channel part of the active layer, the tailing region includes a tailing part of the active layer, and neither the channel region nor the tailing region includes the ohmic contact layer.

In the method of manufacturing the thin film transistor device according to at least one embodiment of the present disclosure, an edge of the ohmic contact layer and an edge of the source/drain electrode layer are substantially aligned in the direction perpendicular to the main surface of the base substrate.

In the method of manufacturing the thin film transistor device according to at least one embodiment of the present disclosure, a thickness of the overlapping part of the active layer is greater than a thickness of the channel part and a thickness of the tailing part of the active layer; and the overlapping part of the active layer has an edge substantially aligned with the edge of the ohmic contact layer and the edge of the source/drain electrode layer in the direction perpendicular to the main surface of the base substrate.

In the method of manufacturing the thin film transistor device according to at least one embodiment of the present disclosure, a thickness uniformity of the channel part and the tailing part of the active layer ranges from 5% to 12%.

In the method of manufacturing the thin film transistor device according to at least one embodiment of the present disclosure, the tailing part of the active layer is free of a stepped structure.

In the method of manufacturing the thin film transistor device according to at least one embodiment of the present disclosure, the source/drain material layer includes a metal material, the active layer includes a semiconductor material, and the ohmic contact layer includes a doped semiconductor material and has a group IIIA doping element or a group VA doping element.

In the method of manufacturing the thin film transistor device according to at least one embodiment of the present disclosure, the tailing region of the active structure is free of a group IIIA doping element or a group VA doping element.

In the method of manufacturing the thin film transistor device according to at least one embodiment of the present disclosure, the first etching solution includes hydrogen peroxide, and the second etching solution includes fluoride.

In the method of manufacturing the thin film transistor device according to at least one embodiment of the present disclosure, among the composite etching solution, a mass fraction of fluoride ions dissociated from the fluoride in the composite etching solution ranges from 0.1% to 0.4%.

In the method of manufacturing the thin film transistor device according to at least one embodiment of the present disclosure, a mass fraction of the hydrogen peroxide in the composite etching solution ranges from 15% to 25%.

In the method of manufacturing the thin film transistor device according to at least one embodiment of the present disclosure, a thickness of the ohmic contact material layer ranges from 100 angstroms to 200 angstroms.

In the method of manufacturing the thin film transistor device according to at least one embodiment of the present disclosure, a thickness of the active material layer ranges from 600 angstroms to 900 angstroms.

In the method of manufacturing the thin film transistor device according to at least one embodiment of the present disclosure, a thickness of a portion of the active structure material layer removed by the wet etching process ranges from 200 angstroms to 400 angstroms.

In the method of manufacturing the thin film transistor device according to at least one embodiment of the present disclosure, the first etching solution and the second etching solution in the composite etching solution are mixed with each other, and the source/drain material layer and the active structure material layer are etched in a single wet etching process.

In the method of manufacturing the thin film transistor device according to at least one embodiment of the present disclosure, the patterned mask layer includes a plurality of mask patterns spaced apart from each other, and a surface of the source/drain material layer away from the active structure material layer is partially exposed before the wet etching process is performed, and an edge of the source/drain material layer laterally extends beyond an edge of the patterned mask layer in the direction parallel to the main surface of the base substrate.

In the method of manufacturing the thin film transistor device according to at least one embodiment of the present disclosure, before the wet etching process, further including: forming an initial mask layer on a side of the source/drain material layer away from the active structure material layer, wherein the initial mask layer includes a first mask pattern region and a second mask pattern region, and a thickness of the first mask pattern region is greater than a thickness of the second mask pattern region.

In the method of manufacturing the thin film transistor device according to at least one embodiment of the present disclosure, further including: performing an initial wet etching process on the source/drain material layer by using the initial mask layer as an etching mask; performing an ashing process on the initial mask layer to remove the second mask pattern region of the initial mask layer and reduce a size of the first mask pattern region, wherein a remaining portion of the first mask pattern region forms the patterned mask layer; and performing a dry etching process on the active structure material layer by using the patterned mask layer and the source/drain material layer as an etching mask, after the initial wet etching process and before the wet etching process using the composite etching solution.

In the method of manufacturing the thin film transistor device according to at least one embodiment of the present disclosure, after performing the wet etching process, further including: removing the patterned mask layer; and forming an insulating layer to cover sidewalls of the source/drain electrode layer and the active structure layer as well as surfaces thereof away from the gate insulating layer, wherein surfaces of the channel part and the tailing part of the active layer away from the gate insulating layer are in contact with the insulating layer; and a contact area between the insulating layer and the channel part and between the insulating layer and the tailing part, is substantially equal to an area of the surfaces of the channel part and the tailing part away from the gate insulating layer.

At least one embodiment of the present disclosure provides a composite etching solution for forming a thin film transistor device, including: a first etching solution and a second etching solution, wherein the first etching solution includes hydrogen peroxide and the second etching solution includes fluoride, the first etching solution is configured to etch a source/drain material layer to form a source/drain electrode layer of a thin film transistor and oxidize an active structure material layer, and the second etching solution is configured to etch an oxidized part of the active structure material layer to form an active structure of the thin film transistor; and a hydrogen peroxide stabilizer and a metal chelating agent, wherein in the composite etching solution, a mass fraction of fluoride ions dissociated from the fluoride ranges from 0.1% to 0.4%.

In the composite etching solution for forming a thin film transistor device according to at least one embodiment of the present disclosure, a mass fraction of the hydrogen peroxide ranges from 15% to 25%.

In the composite etching solution for forming a thin film transistor device according to at least one embodiment of the present disclosure, the fluoride includes at least one selected from a group consisted of hydrofluoric acid and hydrofluride.

In the composite etching solution for forming a thin film transistor device according to at least one embodiment of the present disclosure, the hydrogen peroxide stabilizer is selected from organic acid compounds, and the metal chelating agent is at least one selected from a group consisted of glycine, alanine and iminodiacetic acid.

In the composite etching solution for forming a thin film transistor device according to at least one embodiment of the present disclosure, the first etching solution is configured to react with a metal of the source/drain material layer to generate metal ions, and the metal chelating agent is configured to chelate the metal ions.

In the composite etching solution for forming a thin film transistor device according to at least one embodiment of the present disclosure, in the composite etching solution, a mass fraction of the hydrogen peroxide stabilizer ranges from 1.5% to 4%, and a mass fraction of the metal chelating agent ranges from 1% to 3%.

In the composite etching solution for forming a thin film transistor device according to at least one embodiment of the present disclosure, further including a slope angle regulator, and the slope angle regulator is selected from inorganic acid compounds.

At least one embodiment of the present disclosure provides a thin film transistor device, including: a gate electrode layer, located on a base substrate; a gate insulating layer, located on a side of the gate electrode layer; an active structure, located on a side of the gate insulating layer away from the gate electrode layer; and a source/drain electrode layer, located on a side of the active structure away from the gate insulating layer, wherein the active structure includes an active layer, and an ohmic contact layer located between the active layer and the source/drain electrode layer, and the active structure has overlapping regions, a channel region and a tailing region; the overlapping regions overlap with the source/drain electrode layer in a direction perpendicular to a main surface of the base substrate, the channel region is located between the overlapping regions, and the tailing region laterally extends beyond an edge of the source/drain electrode layer away from the channel region in a direction parallel to the main surface of the base substrate; wherein the ohmic contact layer is located in the overlapping regions, and in the direction perpendicular to the main surface of the base substrate, an orthographic projection of the ohmic contact layer on the base substrate is located within a range of an orthographic projection of the source/drain electrode layer on the base substrate.

In the thin film transistor device according to at least one embodiment of the present disclosure, the ohmic contact layer does not extend into the channel region and the tailing region.

In the thin film transistor device according to at least one embodiment of the present disclosure, the active layer includes an overlapping part, a channel part and a tailing part located in the overlapping regions, the channel region and the tailing region, respectively, and the ohmic contact layer is located between the overlapping part of the active structure and the source/drain electrode layer.

In the thin film transistor device according to at least one embodiment of the present disclosure, the active layer includes a semiconductor material, the ohmic contact layer includes a doped semiconductor material doped with a group IIIA doping element or a group VA doping element, and the tailing region of the active structure does not include a group IIIA doping element or a group VA doping element.

In the thin film transistor device according to at least one embodiment of the present disclosure, the channel region of the active structure does not include a group IIIA doping element or a group VA doping element, either.

In the thin film transistor device according to at least one embodiment of the present disclosure, an edge of the ohmic contact layer and an edge of the source/drain electrode layer are substantially aligned in the direction perpendicular to the main surface of the base substrate.

In the thin film transistor device according to at least one embodiment of the present disclosure, a thickness of the overlapping part of the active layer is greater than a thickness of the channel part and a thickness of the tailing part of the active layer, and the overlapping part of the active layer has an edge substantially aligned with the edge of the ohmic contact layer and the edge of the source/drain electrode layer in the direction perpendicular to the main surface of the base substrate.

In the thin film transistor device according to at least one embodiment of the present disclosure, a thickness of the channel part and a thickness of the tailing part of the active layer are smaller than or equal to a thickness of the overlapping part.

In the thin film transistor device according to at least one embodiment of the present disclosure, a thickness uniformity of the channel part and the tailing part of the active layer ranges from 5% to 12%.

In the thin film transistor device according to at least one embodiment of the present disclosure, further including: an insulating layer, located above the base substrate and covering the source/drain electrode layer and the active structure, wherein the ohmic contact layer has a sidewall in contact with the insulating layer and an end part close to the sidewall, and a surface of the end part of the ohmic contact layer away from the active layer is covered by the source/drain electrode layer and is separated from the insulating layer.

In the thin film transistor device according to at least one embodiment of the present disclosure, surfaces of the channel part and the tailing part of the active layer away from the gate insulating layer are in contact with the insulating layer; and a contact area between the insulating layer and the channel part and between the insulating layer and the tailing part is substantially equal to an area of the surfaces of the channel part and the tailing part away from the gate insulating layer.

In the thin film transistor device according to at least one embodiment of the present disclosure, a thickness of the overlapping part of the active layer ranges from 600 angstroms to 900 angstroms.

In the thin film transistor device according to at least one embodiment of the present disclosure, a thickness of the ohmic contact layer ranges from 100 angstroms to 200 angstroms.

At least one embodiment of the present disclosure provides an array substrate, including any one of the above-mentioned thin film transistor devices.

### BRIEF DESCRIPTION OF THE DRAWINGS

In order to more clearly illustrate the technical solutions of the embodiments of the present disclosure, the drawings of the embodiments will be briefly described in the following; it is obvious that the described drawings are only related to some embodiments of the present disclosure and thus are not limitative to the present disclosure.
FIG. 1A to FIG. 1D are schematic cross-sectional views illustrating a manufacturing method of a thin film transistor device according to some embodiments of the present disclosure.
FIG. 2A illustrates a schematic view of an array substrate including a thin film transistor according to some embodiments of the present disclosure; FIG. 2B illustrates a schematic plan view of a thin film transistor, a gate line, data signal lines and pixel electrodes of an array substrate according to some embodiments of the present disclosure; FIG. 2C and FIG. 2D illustrate schematic cross-sectional views of a thin film transistor device according to some embodiments of the present disclosure.
FIG. 3A to FIG. 3F are schematic cross-sectional views illustrating a manufacturing method of a thin film transistor device according to some other embodiments of the present disclosure.

### DETAILED DESCRIPTION

In order to make objects, technical details and advantages of the embodiments of the present disclosure apparent, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not limited to be a physical connection or mechanical connection, but may include an electrical connection, directly or indirectly.

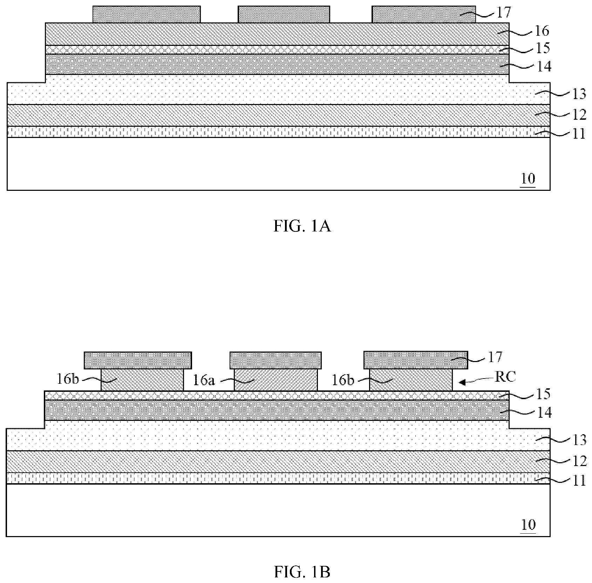

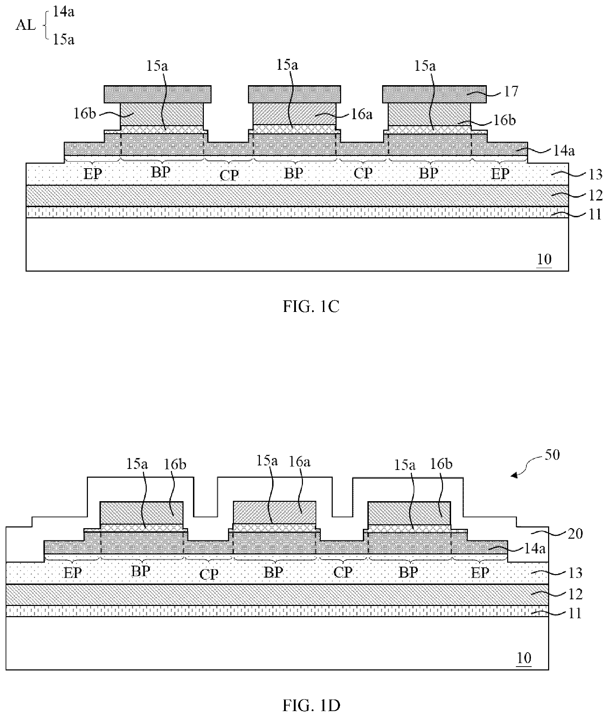

FIG. 1A to FIG. 1D are schematic cross-sectional views illustrating a manufacturing method of a thin film transistor device according to some embodiments of the present disclosure. The thin film transistor device is included in an array substrate of a display device, for example.

Referring to FIG. 1A, in some embodiments, a common electrode layer 11, a gate metal layer 12, a gate insulating layer 13, an active material layer 14, an ohmic contact material layer 15, and a source/drain metal layer 16 are sequentially formed on a base substrate 10. A photoresist layer 17 having a plurality of photoresist patterns spaced apart from each other is formed at a side of the source/drain metal layer 16 away from the ohmic contact material layer 15.

In some embodiments, the active material layer 14 includes a semiconductor material, such as intrinsic amorphous silicon; the ohmic contact material layer 15 includes a doped semiconductor material, including, for example, doped amorphous silicon, and may include a doping element such as a group IIIA doping element (e.g., boron) or a group VA doping element (e.g., phosphorus, arsenic or the like).

Referring to FIGs. 1A to 1B, a wet etching process by using the photoresist layer 17 as an etching mask is performed on the source/drain metal layer 16 to remove some portions of the source/drain metal layer 16 and form a source electrode layer 16a and a drain electrode layer 16b (collectively referred to as a source/drain electrode layer) separated from each other; in some embodiments, when observed in a plan view, the drain electrode layer 16b surrounds at least part of the source electrode layer 16a in a direction parallel to a main surface of the base substrate 10, but the present disclosure is not limited thereto.

Since the wet etching process is isotropic, the source electrode layer 16a and the drain electrode layer 16b as formed are recessed laterally with respect to corresponding sidewalls of the photoresist layer 17, respectively, and lateral recesses RC are formed laterally aside the source electrode layer 16a and the drain electrode layer 16b, and between the photoresist layer 17 and the ohmic contact material layer 15. In some embodiments, the source/drain metal layer 16 includes a metal material such as copper, and an etching solution used in the wet etching process may include hydrogen peroxide. In the etching process, a copper surface is oxidized by the hydrogen peroxide to generate copper oxide, and the copper oxide is dissolved in an acidic solution to generate copper ions, with a reaction equation as follows:

(1) H₂O₂+Cu→CuO+H₂O, (2) CuO + 2H⁺→Cu²⁺ + H₂O.

The above-mentioned two reaction steps are repeated alternately to realize the etching of the source/drain metal layer (for example, a copper layer).

In some embodiments, the etching solution of hydrogen peroxide does not substantially etch the ohmic contact material layer 15 after etching the source/drain metal layer (e.g., a copper layer) 16. Specifically, after the etching of the copper layer by using the etching solution of hydrogen peroxide is completed, the ohmic contact material layer (e.g., a doped silicon layer) 15 located below the source/drain metal layer 16 is oxidized by the etching solution of hydrogen peroxide, with a reaction equation as follows:

2H₂O₂+Si→SiO₂+2H₂O

The ohmic contact material layer 15 being oxidized cannot be further dissolved in an acidic environment of the hydrogen peroxide; that is to say, the above-mentioned etching solution of hydrogen peroxide is only used to etch the source/drain metal layer, but can not further etch the ohmic contact material layer and the active material layer 14 below the ohmic contact material layer.

Referring to FIG. 1B to FIG. 1C, in some embodiments, a dry etching process is subsequently performed on the ohmic contact material layer 15 and the active material layer 14 to remove portions of the ohmic contact material layer 15 and the active material layer 14, and form an ohmic contact layer 15a and an active layer 14a. The ohmic contact layer 15a is located between the active layer 14a and the source electrode layer 16a and between the active layer 14a and the drain electrode layer 16b. In some embodiments, a combination of the active layer 14a and the ohmic contact layer 15a is referred to as an active structure AL.

In some embodiments, the dry etching process is performed on the ohmic contact material layer (including a doped silicon, for example) 15 and the active material layer (including silicon, for example) 14 by using the photoresist layer 17 as an etching mask, and using chlorine, nitrogen trifluoride or the like as an etching gas. Due to the anisotropy of the dry etching process, the etching gas mainly functions to remove portions of the ohmic contact material layer 15 and the active material layer 14 that are not covered by the photoresist layer 17. However, in the process of etching the source/drain metal layer 16 by using the wet etching process illustrated in FIG. 1B, a portion of the source/drain metal layer 16 located directly below the photoresist layer 17 is etched laterally, so that a lateral recess RC is formed laterally aside the source/drain electrode layer SD, and between the photoresist layer 17 and the ohmic contact material layer 15. Therefore, when the dry etching process is performed on the ohmic contact material layer 15 and the active material layer 14, part of the etching gas may enter the lateral recess RC to etch a portion of the ohmic contact material layer 15 covered by the photoresist layer 17 (i.e., the portion located directly below the photoresist layer 17), so that the ohmic contact layer 15a as formed has a tailing part, and the active layer 14a as formed has a stepped structure.

In this way, the active structure AL as formed includes body regions BP, a channel region CP and an extension region EP; the body region BP overlaps with the source/drain electrode layer in the direction perpendicular to the main surface of the base substrate 10; the channel region CP is located between the body regions BP in the direction parallel to the main surface of the base substrate 10; and the extension region EP extends beyond the outermost sidewall of the source/drain electrode layer in the direction parallel to the main surface of the base substrate 10 and away from the channel region CP. The extension region EP may also be referred to as an active tailing. In this embodiment, the active tailing includes a portion of the active layer 14a located in the extension area EP (i.e., the active layer tailing) and a portion of the ohmic contact layer 15a located in the extension region EP (i.e., the first ohmic contact layer tailing), and has a stepped structure; for example, the active layer tailing includes a stepped structure constituted by a first part with a first thickness and a second part with a second thickness greater than the first thickness, and the first ohmic contact layer tailing is located on the second part of the active layer tailing. In some embodiments, the channel region CP of the active structure AL includes a portion of the active layer 14a located in the channel region CP and a portion (i.e., the second ohmic contact layer tailing) of the ohmic contact layer 15a located in the channel region CP. In this embodiment, the portion of the active layer 14a located in the channel region CP may also have a stepped structure, and the second ohmic contact layer tailing is located on this portion of the active layer 14a. Since the ohmic contact layer includes a doping element such as phosphorus, in the extension region EP (i.e., the active tailing), the active tailing includes a doping element such as phosphorus due to the existence of the first ohmic contact layer tailing. On the other hand, due to the existence of the second ohmic contact layer tailing, the channel region CP also includes a doping element such as phosphorus.

Referring to FIGs. 1C to 1D, the photoresist layer 17 is then removed, and an insulating layer 20 is formed on a side of the gate insulating layer 13 away from the base substrate 10, and a thin film transistor device 50 including the gate electrode 12, the gate insulating layer 13, the active layer AL, and the source/drain electrode layer on the base substrate 10 is formed. In this embodiment, the insulating layer 20 covers sidewalls of the active layer 14a and a surface of the active layer 14a away from the gate insulating layer 13, sidewalls of the ohmic contact layer 15a and a surface of the ohmic contact layer 15a away from the active layer 14a, and sidewalls of the source/drain electrode layer and a surface of the source/drain electrode layer away from the ohmic contact layer 15a. In the channel region CP and the extension region EP, a surface of the active layer 14a away from the gate insulating layer 13 is partially covered by the ohmic contact layer 15a, therefore, in these regions, a contact area between the surface of the active layer 14a away from the gate insulating layer 13 and the insulating layer 20 is smaller than an area of the surface of the active layer 14a away from the gate insulating layer 13 and close to the insulating layer 20.

In the above-described process of etching the source/drain metal layer and the active structure material layer (including the ohmic contact material layer and the active material layer) by using a wet etching process in combination with a dry etching process as illustrated in FIGs. 1A to 1C, chlorine is the main etching gas in the dry etching process, and is also an important gas for adjusting an etching selectivity ratio of the semiconductor active layer to the ohmic contact layer. However, chlorine is a highly toxic gas, which is the major hazard source in the manufacturing process of array substrates at present with high risk factor; furthermore, chlorine has strong corrosiveness to a dry etching equipment, which requires for expensive equipment maintenance, and results in an overall higher cost for etching.

On the other hand, in the process steps above, the source/drain metal layer and the active structure material layer are etched by using the combination of wet etching process and dry etching process, through which the active tailing as formed would have a stepped structure and includes an ohmic contact layer tailing, and the channel region of the active structure also has a stepped structure and may include an ohmic contact layer tailing, which in turn causes the active tailing and the channel region of the active structure to include a doping element such as phosphorus. However, such ohmic contact layer tailing in the active structure may adversely affect the device performance; for example, it may increase an off-state leakage current and a static electricity-related defective rate of the thin film transistor, thereby degrading device performances of a TFT array substrate.

Moreover, in the dry etching process, a surface of a film layer being etched (the active structure material layer including the ohmic contact material layer 15 and the active material layer 14) is bombarded by using plasma, which results in a poor thickness uniformity of the film layer (the active structure AL including the ohmic contact layer 15a and the active layer 14a) formed by the dry etching process. As such, in order to ensure that the portion of the active layer 14a located in the channel region CP after the etching process has an enough thickness to meet the device performance, an active structure material layer with a relatively large thickness is usually formed before the etching process. For example, a sum of a thickness of the ohmic contact material layer 15 and a thickness of the active material layer 14 is about 2000 angstroms, in which the thickness of the ohmic contact material layer 15 is about 300 angstroms and the thickness of the active material layer 14 is about 1700 angstroms. However, an active structure material layer with a large thickness will result in a large size (e.g., thickness) of the active tailing as formed, which may also adversely affect the device performance; for example, it may increase an off-state leakage current, a static electricity-related defective rate, etc., of the thin film transistor, and further degrade the device performances of the TFT array substrate.

In order to solve the abovementioned problems, some other embodiments of the present disclosure provide a thin film transistor device and a manufacturing method thereof, as well as a composite etching solution for forming the thin film transistor device. The thin film transistor device is applied to an array substrate of an LCD, for example. According to the manufacturing method of the thin film transistor device, in process steps of forming a source/drain electrode layer and an active structure by etching, a composite etching solution is utilized to etch a source/drain material layer and an active structure material layer (for example, including an ohmic contact material layer and an active material layer) by a single wet etching step, which can reduce the step of the dry etching process and hence reduce the use of chlorine, thereby improving the production safety, increasing the production efficiency and lowering the production cost. On the other hand, in the thin film transistor device formed by using the etching method, the ohmic contact layer tailings in the active tailing can be eliminated, so as to avoid an adverse influence caused by the ohmic contact layer tailings and hence to improve the device performances.

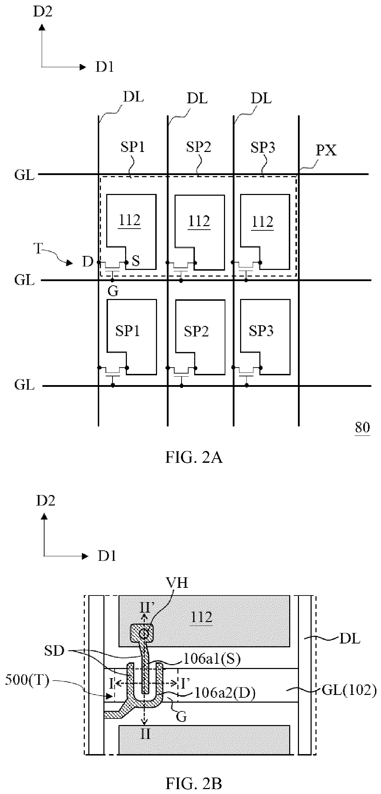

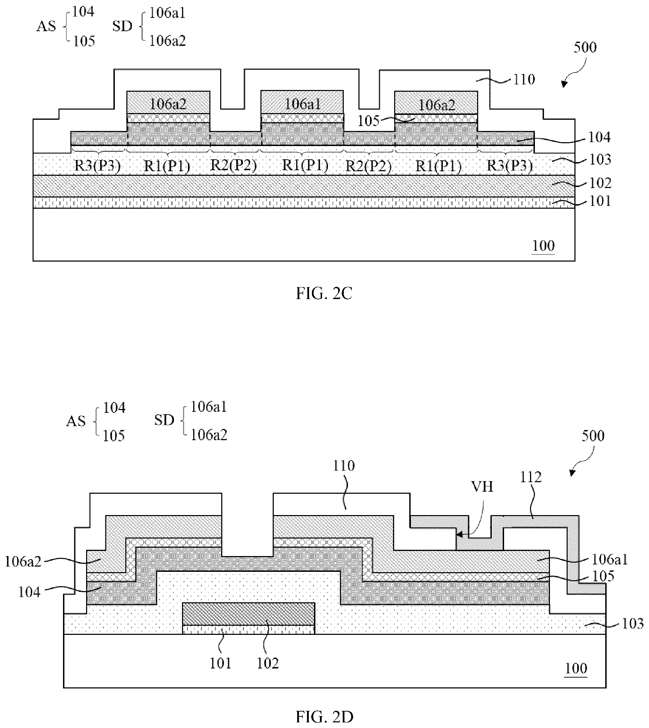

FIG. 2A illustrates a schematic diagram of an array substrate according to some embodiments of the present disclosure, and FIG. 2B illustrates a schematic plan view of thin film transistors, gate lines, data signal lines and pixel electrodes of the array substrate according to some embodiments of the present disclosure; FIG. 2C and FIG. 2D illustrate schematic cross-sectional views of a thin film transistor device according to some embodiments of the present disclosure, and are cross-sectional views taken along a line I-I" and a line II-II'' of FIG. 2B, respectively.

Referring to FIG. 2A, in some embodiments, an array substrate 80 includes a plurality of gate lines GL and a plurality of data signal lines DL. In some embodiments, the plurality of gate lines GL extend substantially parallel to each other along a direction D1 and are arranged along a direction D2; the plurality of data signal lines DL extend substantially parallel to each other along the direction D2 and are arranged along the direction D1. The plurality of gate lines GL and the plurality of data signal lines DL extend cross each other to define a plurality of pixel regions PX. For example, in a display area of the array substrate, a plurality of pixel regions PX are arranged in an array along the direction D1 and the direction D2, and each of the pixel regions PX may include one or more sub-pixel regions, such as sub-pixel regions SP1, SP2 and SP3. Each of the sub-pixel regions SP1-SP3 is defined by adjacent gate lines GL and adjacent data signal lines DL that cross each other. The plurality of sub-pixel regions SP1, SP2 and SP3 included in the pixel region PX may be pixel regions for displaying different colors (for example, red, green and blue). It should be understood that the number of the pixel regions PX illustrated in FIG. 2A and the number of the sub-pixel regions included in each of the pixel regions PX are only illustrative, and the number of the pixel regions PX and the number of the sub-pixel regions included in each of the pixel regions PX are not limited in the present disclosure.

In some examples, a pixel electrode 112 is provided in each of the sub-pixel regions. The array substrate 80 further includes a plurality of thin film transistors T, and each of the thin film transistors T includes a gate electrode G, a source electrode S and a drain electrode D. In some embodiments, the gate electrode G of the thin film transistor T is connected to the gate line GL, one of the source electrode S and the drain electrode D (for example, the drain electrode D) is connected to the data signal line DL, and the other one of the source electrode S and the drain electrode D (for example, the source electrode S) is connected to the pixel electrode 112. In some embodiments, the plurality of thin film transistors T are arranged in an array along the direction D1 and the direction D2, the gate line GL connects the gate electrodes G of a plurality of thin film transistors T arranged in the same row along the direction D1, and the data signal line DL connects the drain electrodes D of a plurality of thin film transistors T arranged in the same column along the direction D2. In some embodiments, the array substrate 80 further includes a common electrode (Vcom). In a display stage, an electric field is formed between the common electrode and the pixel electrode 112 to drive liquid crystal molecules in the display device to deflect, thereby completing an image display. It should be understood that, the pixel circuit illustrated in FIG. 2A is only illustrative and mainly illustrates connection relationships among the respective components; shapes of the respective components illustrated in the figure are only illustrative, and the present disclosure is not limited thereto.

Referring to FIG. 2B to FIG. 2D, in some embodiments, a thin film transistor device 500 includes a base substrate 100, a gate electrode layer 102, a gate insulating layer 103, an active structure AS, and a source/drain electrode layer SD. The thin film transistor device 500 includes a thin film transistor T. In some embodiments, a common electrode layer 101 may be disposed on a side of the gate electrode layer 102, for example, on a side of the gate electrode layer 102 close to the base substrate 100. In some embodiments, the gate electrode layer 102 may be or include a layer where the gate electrode G is located, and the source/drain electrode layer SD may include a source electrode layer 106a1 and a drain electrode layer 106a2. At least part of the gate electrode layer 102 serves as the gate electrode G of the thin film transistor T, at least part of the source electrode layer 106a1 serves as the source electrode S of the thin film transistor T, and at least part of the drain electrode layer 106a2 serves as the drain electrode D of the thin film transistor T. In some embodiments, the source electrode layer 106a1 further includes an extension part connected with the source electrode S, and the extension part extends to a position overlapped with the pixel electrode 112 in a direction perpendicular to a main surface of the base substrate and is electrically connected with the pixel electrode 112 through a via hole VH. In some embodiments, the drain electrode layer 106a2 further includes an extension part connected with the drain electrode D, and the extension part extends from the drain electrode D to be connected with the data signal line DL. In some embodiments, a portion (e.g., the drain electrode D) of the drain electrode layer 106a2 surrounds a portion (e.g., the source electrode S) of the source electrode layer 106a1 in a direction parallel to the main surface of the base substrate. By way of example, a portion (e.g., the source electrode S) of the source electrode layer 106a1 has a strip shape, and a portion (e.g., the drain electrode D) of the drain electrode layer 106a2 has an opened ring shape, such as a U shape or the like. However, the present disclosure is not limited thereto.

In some embodiments, the thin film transistor device 500 further includes an insulating layer 110 and a pixel electrode 112, and the insulating layer 110 is disposed on a side of the gate insulating layer 103 away from the base substrate, and covers the active structure AS and the source/drain electrode layer SD; the insulating layer 110 has a via hole VH, and the pixel electrode is electrically connected to the source electrode layer 106a1 through the via hole VH.

In some embodiments, in the cross-sectional view FIG. 2C taken along the line I-'I' along the direction D1, the active structure AS has a tailing region R3 extending beyond the source/drain electrode layer SD; and in the cross-sectional view FIG. 2D taken along the line II-II'' along the direction D2, an edge of the active structure AS (including the active layer 104 and the ohmic contact layer 105) is substantially aligned with an edge of the source/drain electrode layer SD, for example, the edges thereof are substantially aligned in the direction perpendicular to the main surface of the base substrate 100. Structural features of the thin film transistor device 500 will be described in details in connection with the manufacturing process thereof as below.

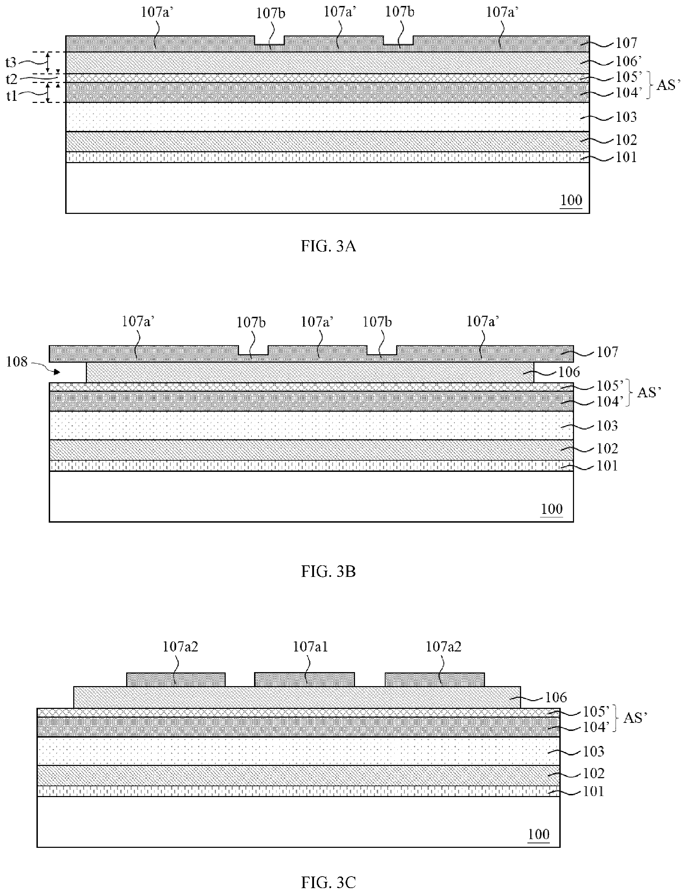

FIG. 3A to FIG. 3F illustrate a manufacturing method of the thin film transistor device 500 according to some embodiments of the present disclosure, in which a single wet etching step is performed on a source/drain material layer and an active structure material layer by using a composite etching solution in a process step of forming a source/drain electrode layer and an active structure.

In some embodiments, the composite etching solution includes a first etching solution and a second etching solution; the first etching solution and the second etching solution may be mixed with each other, that is, the composite etching solution includes a mixture of the first etching solution and the second etching solution, but the present disclosure is not limited thereto. For example, the first etching solution may be or include hydrogen peroxide (H₂O₂), and the second etching solution may be or include a fluorine-containing compound that can be dissociated to generate fluorine ions in an environment of the first etching solution; for example, the second etching solution may be at least one selected from fluorides such as hydrofluoric acid and hydrofluride. In some examples, the second etching solution may be or include ammonium fluoride or ammonium bifluoride.

In some embodiments, the first etching solution is configured to etch the source/drain material layer and oxidize the active structure material layer (for example, an ohmic contact material layer including a doped semiconductor material and/or an active material layer including an intrinsic semiconductor material); the second etching solution is configured to etch the portion of the active structure material layer that has been oxidized by the first etching solution, so that the composite etching solution can realize the etching of the source/drain material layer and the active structure material layer in a single wet etching step.

For example, the source/drain material layer includes a metal material such as copper; the active structure material layer includes a semiconductor material such as silicon; for example, the active structure material layer may include an intrinsic semiconductor material such as amorphous silicon; the ohmic contact material layer includes a doped semiconductor material such as doped amorphous silicon, and may include a doping element such as phosphorus. In etching the source/drain material layer and the active structure material layer by using the composite etching solution, reaction equations as follows are involved:

(a) H₂O₂+Cu→CuO+H₂O, CuO + 2H⁺→Cu²⁺ + H₂O

(b) 2H₂O₂+Si→SiO₂+2H₂O, SiO₂+6F⁻+4H⁺→SiF₆²⁻+2H₂O.

As illustrated in the reaction equation (a), the hydrogen peroxide, as the first etching solution, etches the source/drain material layer including a metal material such as copper, so as to dissolve the metal copper. It should be noted that, herein, the principle of the etching process using the first etching solution is illustrated here taken copper as an example only, and the source/drain material layer is not limited to including copper, but may also including other metal materials such as molybdenum-niobium alloy (Mo-Nb alloy), which can also be etched by the first etching solution. As illustrated in the reaction equation (b), after etching the source/drain material layer, the hydrogen peroxide in the first etching solution oxidizes the silicon in the active structure material layer to form silicon oxide, and then the fluoride ions that are generated by dissociating the fluoride of the second etching solution in an environment of acidic aqueous solution react with the silicon oxide to form a soluble compound including SiF₆²⁻, thereby realizing the etching of the active structure material layer. In some embodiments, by repeating the reaction steps illustrated in the reaction equation (b), the etching of the ohmic contact material layer in the active structure material layer can be realized, and part of the active material layer may also be optionally etched.

In some embodiments, in the composite etching solution (i.e., with respect to a total mass of the composite etching solution), mass fractions of the first etching solution and the second etching solution need to be set in a suitable range, so that the composite etching solution can effectively etch the source/drain material layer and the active structure material layer, and defects such as ohmic contact tailing can be avoided. In some embodiments, an etching rate of the source/drain material layer (e.g., copper layer and/or Mo-Nb alloy layer) is approximately proportional to a content of the first etching solution (e.g., hydrogen peroxide). In some embodiments, the etching rates of using the hydrogen peroxide to etch the copper layer and to etch the Mo-Nb alloy layer are approximately the same. For example, in the composite etching solution, the mass fraction of hydrogen peroxide in the first etching solution is in the range from 15% to 25%. The mass fraction of hydrogen peroxide is greater than 15%, which enables the first etching solution to effectively etch the source/drain material layer, and avoids a poor etching rate of the source/drain material layer due to too small content of hydrogen peroxide; and the mass fraction of hydrogen peroxide is smaller than 25%, which enables the etching rate of the source/drain material layer to be within a suitable range, and prevents an excessively higher etching rate of the source/drain material layer resulted by an excessively higher content of hydrogen peroxide from hindering a satisfied control of the etching process.

In some embodiments, in the composite etching solution, a mass fraction of fluoride ions dissociated from fluoride of the second etching solution in an environment of the etching solution (e.g., acidic aqueous solution) is in the range of 0.1% to 0.4%. The mass fraction of fluoride ions being greater than or equal to 0.1% enables the etching solution to effectively etch the active structure material layer, and make the formed active structure be free of ohmic contact tailing. In some embodiments, an etching rate of the active structure material layer (e.g., amorphous silicon) is approximately proportional to a content of fluorine ions in the second etching solution. An excessively low content (e.g., smaller than 0.1%) of fluorine ions may lead to an excessively low etching rate of the active structure material layer, which results in that the active structure material layer cannot be effectively etched within a certain etching time, and further results in that an ohmic contact residue may exist in the tailing region and channel region of the active structure as formed after etching or other issues. On the other hand, if the content of fluorine ions is excessively low (e.g., smaller than 0.1%), in order to increase an etching amount of the active structure material layer, the etching time is increased, which may also increase a lateral etching amount of the source/drain material layer and adversely affect a final size of the source and drain electrodes. Therefore, by setting the mass fraction of fluoride ions to be above 0.1%, the above-mentioned problems caused by an excessively low content of fluoride ions can be avoided.

On the other hand, in some embodiments, fluoride ions may affect the etching rate of the source/drain material layer; and in the case where the source/drain material layer includes multi-layered metal materials such as a Mo-Nb alloy layer and a copper layer, fluoride ions may have different effects on different metal materials. For example, the hydrogen peroxide may have substantially the same etching rate for the Mo-Nb alloy layer and the copper layer, while the fluoride ions may accelerate the etching rate for the Mo-Nb alloy layer, and may reduce the etching rate for the copper layer. If the content of fluoride ions is set within a suitable range (e.g., within about 0.4%), the above-mentioned influence of fluoride ions on the Mo-Nb alloy layer and the copper layer will be unconspicuous and can be ignored, or, the above-mentioned influence of fluoride ions on the Mo-Nb alloy layer and the copper layer is little and would not cause too much difference in etching rates between the Mo-Nb alloy layer and the copper layer; that is, within the abovementioned range, the etching rates of the copper layer and the Mo-Nb alloy layer can be kept approximately consistent, and the lateral etching amounts for the copper layer and the Mo-Nb alloy layer are substantially the same. However, if the content of fluorine ions is excessively high (for example, greater than about 0.4%), the above-mentioned influence of fluorine ions on the etching rate of the source/drain material layer will be conspicuous, which accelerates the etching rate for the Mo-Nb alloy layer and decreases the etching rate for the copper layer, and hence causes an enlarged difference between the etching rates for the Mo-Nb alloy layer and the copper layer; as such, the etching rate for the Mo-Nb alloy layer is greater than the etching rate for the copper layer in the source/drain material layer, and the lateral etching amount of the Mo-Nb alloy layer is greater than that of the copper layer, thereby resulting in that the Mo-Nb alloy layer in the source/drain electrode layer as formed has an undercut, that is, an edge of the Mo-Nb alloy layer is laterally recessed with respect to an edge of the copper layer; such an undercut may cause a subsequently formed layer to be collapsed and further affect the device performances. Therefore, in the embodiment of the present disclosure, by setting the mass fraction of fluorine ions to be within (i.e., less than or equal to) 0.4%, the above-mentioned adverse effects on the etching of the source/drain material layer due to excessively high content of fluorine ions can be avoided, which further avoid undercut and other defections in the source/drain electrode layer from being occurred.

In some embodiments, the composite etching solution further includes a hydrogen peroxide stabilizer, a metal chelating agent, a slope angle regulator, water and the like.

The hydrogen peroxide stabilizer can prevent or reduce a self-decomposition of hydrogen peroxide, so as to improve the stability of the etching solution. For example, hydrogen peroxide in the first etching solution may be self-decomposed, and free metal ions (for example, copper ions) generated in the etching process may promote the decomposition of hydrogen peroxide, which will lead to a degradation of the stability of the etching solution and adversely affect the above etching process. In this embodiment, a hydrogen peroxide stabilizer is added to avoid or reduce the decomposition of hydrogen peroxide, thereby improving the stability of the etching solution.

The hydrogen peroxide stabilizer may be selected from organic acid compounds, for example, it may include iminodiacetic acid. In some embodiments, a mass fraction of hydrogen peroxide stabilizer in the composite etching solution may be in the range of 1.5% to 4%, or in the range of 2% to 4%.

The metal chelating agent may chelate with the metal ions to generate a stable chelate. For example, in the embodiment where the source/drain material layer includes copper, the first etching solution etches the copper to generate copper ions, and the metal chelating agent can chelate with the copper ions to generate a stable copper chelate by encapsulating the copper ions within the chelating agent, thus preventing the copper ions from promoting the decomposition of hydrogen peroxide and further improving the stability of the etching solution.

In some embodiments, the metal chelating agent may be selected from at least one of organic acids such as glycine, alanine and iminodiacetic acid. In the composite etching solution, a mass fraction of the metal chelating agent may be in the range of 1% to 3%.

The slope angle regulator may be used for adjusting a slope angle of an edge of the film layer formed by etching, and the slope angle can be adjusted depending on product requirements. In some embodiments, the slope angle regulator may be or include an inorganic acid compound, for example, may be selected from at least one of ammonium sulfate, phosphoric acid, sulfuric acid and the like. In the composite etching solution, a mass fraction of the slope angle regulator may be in the range of 0.3% to 0.6%.

In some embodiments, the composite etching solution further includes water, such as any one selected from deionized water, distilled water and ultrapure water.

The application of the composite etching solution in the manufacturing method will be described below in conjunction with the manufacturing method for the thin film transistor device illustrated in FIG. 3A to FIG. 3F.

Referring to FIG. 3A, a base substrate 100 is provided, which may be or include a rigid substrate or a flexible substrate. For example, a material of the base substrate 100 may be glass, polyimide, polycarbonate, polyethylene, polyacrylate or polyethylene terephthalate, but the present disclosure is not limited thereto.

In some embodiments, a common electrode layer 101 and a gate electrode layer 102 are sequentially formed on the base substrate 100. The common electrode layer 101 may include an electrode material such as indium tin oxide (ITO), and the gate electrode layer 102 includes a conductive material such as metal, or metal alloy, for example, copper. In some embodiments, a method of manufacturing the common electrode layer 101 and the gate electrode layer 102 includes depositing a common electrode material layer and a gate material layer on a side of the base substrate 100, and then patterning the gate material layer and the common electrode material layer by, for example, photolithography and etching processes to form the common electrode layer 101 and the gate electrode layer 102. It should be understood that this embodiment illustrates a manufacturing method of the thin film transistor device with reference to the case where the thin film transistor is applied in an array substrate of a display device by way of example, in which the common electrode layer 101 is a part of the array substrate but not a part of the thin film transistor. In some other embodiments, the thin film transistor device can also be applied to other types of electronic devices, and the common electrode layer 101 may not be provided between the base substrate 100 and the gate electrode layer 102, or other types of film layers may be provided therebetween.

In some embodiments, a gate insulating layer 103, an active structure material layer AS' including an active material layer 104' and an ohmic contact material layer 105', and a source/drain material layer 106' are formed on a side of the gate electrode layer 102 away from the base substrate 100.

For example, the gate insulating layer 103 may include an insulating material such as silicon oxide, silicon nitride, silicon oxynitride, the like, or combinations thereof. The gate insulating layer 103 may be formed by a deposition process such as chemical vapor deposition (CVD).

An active structure material layer AS' including an active material layer 104' and an ohmic contact material layer 105' is formed on a side of the gate insulating layer 103 away from the gate electrode layer 102. In some embodiments, the active material layer 104' includes a semiconductor material such as silicon, for example, includes amorphous silicon, and may be referred to as a semiconductor layer. By way of example, the active material layer 104' includes an intrinsic semiconductor material, and may include an element such as silicon and hydrogen but does not include a group IIIA (e.g., boron) doping element or a group VA (e.g., phosphorus) doping element, for example, the active material layer 104' includes intrinsic amorphous silicon. The ohmic contact material layer 105' includes a doped semiconductor material such as doped silicon, for example, includes doped amorphous silicon. Based on the conductivity type of the thin film transistor, the ohmic contact material layer 105' may include a group VA doping element such as phosphorus or a group IIIA doping element such as boron; by way of example, in an N-type thin film transistor, the ohmic contact material layer 105' may include a group VA doping element such as phosphorus, and in a P-type thin film transistor, the ohmic contact material layer 105' may include a group IIIA doping element such as boron; the embodiment of the present disclosure is not intended to limit the type of the thin film transistor.

In some embodiments, the active structure material layer AS' including the active material layer 104' and the ohmic contact material layer 105' may be formed by the following process: forming an active structure material layer, such as a semiconductor material layer, on a side of the gate insulating layer 103 away from the gate electrode 102 by a deposition process such as CVD or physical vapor deposition (PVD), then performing an ion implantation process on the semiconductor material layer to implant a doping element (such as phosphorus) into a surface layer of the semiconductor material layer. In this way, the surface layer of the active structure material layer AS' that includes the doping element forms the ohmic contact material layer 105', and the undoped portion of the active structure material layer AS' forms the active material layer 104'.

In some embodiments, a thickness range of the active structure material layer AS' is about 700 angstroms (Å) to about 1200 angstroms, about 700 angstroms to about 1100 angstroms, about 800 angstroms to about 1100 angstroms, or about 1150 angstroms to 1200 angstroms. However, the present disclosure is not limited thereto, and the thickness of the active structure material layer AS' can be appropriately adjusted according to the actual needs of products. The thickness of the active structure material layer AS' refers to a thickness thereof in a direction substantially perpendicular to the main surface of the base substrate 100. In some embodiments, a thickness t1 of the active material layer 104' may be about 600 angstroms to 900 angstroms, and a thickness t2 of the ohmic contact material layer 105' may be about 100 angstroms to 200 angstroms. However, the present disclosure is not limited thereto.

Still referring to FIG. 3A, a source/drain material layer 106' is formed on a side of the active structure material layer AS' away from the gate insulating layer 103 (that is, a side of the ohmic contact material layer 105' away from the active material layer 104'). By way of example, the source/drain material layer 106' may include a metal material such as metal, metal alloy or a combination thereof, such as copper, molybdenum, niobium, alloys thereof, or combinations thereof; in an example, the source/drain material layer includes copper and Mo-Nb alloy, but the present disclosure is not limited thereto.

The source/drain material layer 106' may be a single-layered structure or a multi-layered structure. In an embodiment where the source/drain material layer 106' is a single-layered structure, the source/drain material layer may be a copper layer; in an embodiment where the source/drain material layer is a multi-layered structure, the source/drain material layer may include a first source/drain material layer and a second source/drain material layer located on a side of the first source/drain material layer away from the active structure material layer AS'. By way of example, the first source/drain material layer may be or include a molybdenum-niobium (Mo-Nb) alloy layer, and the second source/drain material layer may be a copper layer, but the present disclosure is not limited thereto. In some embodiments, a thickness t3 of the source/drain material layer 106' may be about 3100 angstroms to 6300 angstroms, or about 3000 angstroms to 6000 angstroms. In the case where the source/drain material layer 106' includes a first source/drain material layer (Mo-Nb alloy layer) and a second source/drain material layer (copper layer), a thickness of the first source/drain material layer may range from 100 angstroms to 300 angstroms, such as 150 angstroms, and a thickness of the second source/drain material layer may range from about 3000 angstroms to 6000 angstroms, but the present disclosure is not limited thereto. The thickness of the source/drain material layer 106' may be adjusted depending on product requirements.

In some embodiments, an initial mask layer 107 is formed on a side of the source/drain material layer 106' away from the active structure material layer AS'. The initial mask layer 107 may be or include a patterned photoresist layer, and may be formed by depositing a photoresist layer on the source/drain material layer 106' and then pattering the photoresist layer by performing a photolithography process on the photoresist layer.

Referring to FIG. 2A, in some embodiments, the initial mask layer 107 includes a first mask pattern region 107a' and a second mask pattern region 107b, and a thickness of the first mask pattern region 107a' is greater than that of the second mask pattern region 107b. Here, the thickness of the mask pattern region refers to a thickness thereof in the direction perpendicular to the main surface of the base substrate 100. By way of example, a photolithography process may be performed on the photoresist layer by using a photomask including a half-tone region to form the mask layer 107 including mask pattern regions with different thicknesses. For example, in the photolithography process, the second mask pattern region 107b with a smaller thickness is located at a position corresponding to the half-tone region of the photomask.

Referring to FIG. 3A to FIG. 3B, a wet etching process is performed on the source/drain material layer 106' using the initial mask layer 107 as an etching mask, so as to remove some portions of the source/drain material layer 106', for example, a portion of the source/drain material layer 106' located in the pixel region of the array substrate is removed, so as to form a patterned source/drain material layer 106.

In some embodiments, the wet etching process may also be referred to as an initial wet etching process, and an etching solution of the wet etching process includes hydrogen peroxide. In some embodiments, the etching solution used in the initial wet etching process substantially does not etch the active structure material layer AS'. Due to an isotropy of the wet etching process, a portion of the source/drain material layer 106' covered by the initial mask layer 107 is also etched and removed, so that the source/drain material layer 106 as formed is laterally recessed from a sidewall of the mask layer 107 in a direction parallel to the main surface of the base substrate 100, and a lateral recess 108 is formed laterally aside the source/drain material layer 106, and between the initial mask layer 107 and the active structure material layer AS'.

Referring to FIG. 3B to FIG. 3C, in some embodiments, a patterning process is performed on the initial mask layer 107 to remove part of the first mask pattern region 107a' and remove (for example, completely remove) the second mask pattern region 107b', and to form a patterned mask layer including a plurality of mask patterns 107a1 and 107a2. By way of example, part of the first mask pattern region 107a' is removed, so that a size (e.g., thickness, width, etc.) of the first mask pattern region 107a' is reduced, for example, a thickness of the first mask pattern region 107a' in a direction perpendicular to the main surface of the base substrate 100 and its lateral size (width) in a direction parallel to the main surface of the base substrate 100 are both reduced; the second mask pattern region 107b' is completely removed to expose the underlying source/drain material layer 106. Thus, as illustrated in FIG. 3C, the patterned mask layer 107 includes a plurality of mask patterns 107a1 and 107a2 formed from the first mask pattern region 107a'. In some embodiments, the above-mentioned patterning process may include, for example, removing the portions of the initial mask layer 107 through an ashing process.

Referring to FIG. 3C, the plurality of mask patterns 107a1 and 107a2 are located on a side of the source/drain material layer 106 away from the active structure material layer AS'. The plurality of mask patterns 107a1 and 107a2 are spaced apart from each other to expose part of the surface of the source/drain material layer 106 away from the active structure material layer AS'. In some embodiments, because a lateral size of the first mask pattern region 107a' is reduced in the ashing process, an end part of the source/drain material layer 106 laterally protrudes beyond the outermost edge of the plurality of mask patterns (for example, an edge of the mask pattern 107a2) in a direction parallel to the main surface of the base substrate 100 after the mask patterns are formed, so that there is no mask layer overlying and masking the end part of the source/drain material layer 106, that is, the recess 108 as illustrated in FIG. 3B is eliminated.

Referring to FIG. 3C to FIG. 3D, an etching process is performed on the active structure material layer AS' to remove a portion of the active structure material layer AS', for example, a portion of the active structure material layer AS' located in the pixel region of the array substrate. In some embodiments, the etching process may be or include a dry etching process, and the source/drain material layer 106 and the mask patterns serve as an etching mask for the dry etching process. Due to an anisotropy of the dry etching process, after the etching process, an edge (e.g., a sidewall) of the active structure material layer AS' is substantially aligned with an edge (e.g., a sidewall) of the source/drain material layer 106 in the direction perpendicular to the main surface of the base substrate 100. In this step, since there is no mask layer above the source/drain material layer 106 that extends beyond the end part thereof during the dry etching process, the active structure material layer AS' formed by this etching process does not have a stepped structure or a tailing structure.

In some embodiments, during the dry etching process of removing the active structure material layer AS', a portion of the gate insulating layer 103 may be removed by over-etching, so as to ensure that the portion of the active structure material layer AS' not covered by the source/drain material layer 106 is completely removed. In some embodiments, the etching process illustrated in FIG. 3B to FIG. 3D (including a wet etching process and a dry etching process, for example) may also be referred to as an initial etching process of the source/drain material layer and the active structure material layer, and the initial etching process is used for removing a portion of the source/drain material layer and a portion of the active structure material layer that are located outside the region of the thin film transistor device (for example, the portions of these layers located in the pixel regions).

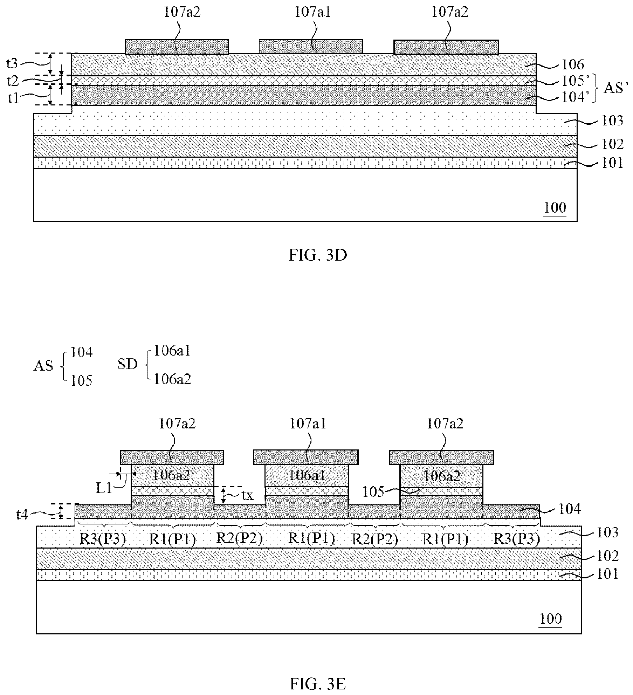

Referring to FIG. 3D to FIG. 3E, a patterning process is then performed on the source/drain material layer 106 and the active structure material layer AS' to form a source/drain electrode layer SD and an active structure AS. In some embodiments, the patterning process includes: performing a wet etching process to the source/drain material layer 106 and the active structure material layer AS' using a patterned mask layer including the mask patterns 107a1 and 107a2 as an etching mask and using the above-mentioned composite etching solution, so as to remove part of the source/drain material layer 106 and part of the active structure material layer AS'. For example, the composite etching solution removes the portions of the source/drain material layer 106 and the active structure material layer AS' that are not covered by the mask patterns 107a1 and 107a2; furthermore, due to the isotropy of the wet etching process, some portions of the source/drain material layer 106 and the active structure material layer AS' that are covered by the mask patterns 107a1 and 107a2 (i.e., located directly below the mask patterns) are also removed, so that edges of the source/drain material layer 106 and the active structure material layer AS' are laterally recessed from corresponding edges of the mask patterns in a direction parallel to the main surface of the base substrate 100. A size that the edges of the source/drain material layer 106 and the active structure material layer AS' are recessed with relative to the corresponding edges of the mask patterns (that is, a distance between the edges of these layers and the corresponding edges of the mask patterns in the direction parallel to the main surface of the base substrate 100 after etching) can also be referred to as a lateral etching amount of these layers. For example, the lateral etching amount of the source/drain material layer 106 is L1.

In the embodiments of the present disclosure, since both the source/drain material layer 106 and the active structure material layer AS' can be etched by using the composite etching solution, the source/drain material layer 106 and the active structure material layer AS' can be patterned in a single wet etching step (i.e., one wet etching step). In the present disclosure, "a single (or one) wet etching" refers to a wet etching by using a same one mask layer and a same etching solution. After the wet etching process, the source/drain material layer 106 is patterned into a source/drain electrode layer SD including a source electrode layer 106a1 and a drain electrode layer 106a2. It should be understood that the source electrode layer and the drain electrode layer are interchangeable. For example, in some embodiments, the source electrode layer 106a1 can be used as the drain electrode layer, and the drain electrode layer 106a2 can be used as the source electrode layer. The active structure material layer AS' is patterned into an active structure AS including an active layer 104 and an ohmic contact layer 105.

Still referring to FIG. 3D to FIG. 3E, in some embodiments, performing the wet etching process by adopting the above-mentioned composite etching solution including the first etching solution and the second etching solution mixed with each other includes the following steps: (1) the first etching solution including hydrogen peroxide etches the source/drain material layer (for example, a copper layer, or a combination of a Mo-Nb alloy layer and a copper layer) 106 to remove a portion of the source/drain material layer 106 not covered by the mask patterns 107a1 and 107a2, and laterally etching portions of the source/drain material layer 106 covered by the mask patterns 107a1 and 107a2 to form a source electrode layer 106a1 and a drain electrode layer 106a2 (collectively referred to as a source/drain electrode layer SD); (2) then, the first etching solution oxidizes at least a portion of the ohmic contact material layer (e.g., a doped silicon layer) 105' not covered by the source/drain electrode layer SD, so that the portion of the ohmic contact material layer is formed as an oxidized ohmic contact material layer (e.g., a silicon oxide layer is formed); and (3) thereafter, the oxidized ohmic contact material layer is etched and dissolved by the second etching solution including fluoride. In some embodiments, in order to ensure that the portion of the ohmic contact material layer not covered by the source/drain electrode layer is completely removed, the etching process further includes over-etching a portion of the active material layer 104' to form an active layer 104. The etching step of removing the portion of the active material layer 104' is similar to the step of etching the ohmic contact material layer and includes the following steps, for example, (4) a portion of the active material layer 104' not covered by the source/drain electrode layer SD is oxidized by the first etching solution, so that the portion of the active material layer 104' is formed as an oxidized active material layer (for example, a silicon oxide layer is formed); and (5) subsequently, the oxidized active material layer is etched and dissolved by the second etching solution including fluoride. However, the embodiment of the present disclosure is not limited thereto. In some other embodiments, the etching process may be stopped when the active material layer 104' is just exposed, that is, the active material layer is not etched substantially.

It should be understood that the above steps (1)-(5) are only illustrative for some steps included in the etching process, but are not intended to limit the order of these steps. The etching steps (1)-(5) may be conducted sequentially, and may not be conducted sequentially; for example, some of these steps may be conducted alternately, or one or more steps may be conducted simultaneously, and the embodiment of the present disclosure is not intended to limit the order of these steps in the etching process. For example, in the etching of the active structure material layer, the step of oxidizing the active structure material layer with the first etching solution and the step of etching the oxidized portion of the active structure material layer with the second etching solution can be conducted alternately to complete the etching of the ohmic contact material layer and/or the active material layer of the active structure material layer. For example, the step (2) and the step (3) may be conducted alternately for one or more times to complete the etching of the ohmic contact material layer, and then the step (4) and the step (5) may be conducted alternately for one or more times to etch a portion of the active material layer 104'. Alternatively, the step (2) of oxidizing the ohmic contact material layer with the first etching solution and the step (4) of oxidizing the active material layer with the first etching solution can be conducted simultaneously, and then the step (3) of etching the oxidized ohmic contact material layer with the second etching solution and the step (5) of etching the oxidized active material layer with the second etching solution can be conducted simultaneously. Moreover, the step (1) and the steps (2)-(5) may be conducted successively or conducted simultaneously . However, the above-mentioned sequence of steps is only illustrative, and the present disclosure is not limited thereto.

Still referring to FIG. 3D and FIG. 3E, in some embodiments, the manufacturing method of the thin film transistor device further includes adjusting a thickness of the ohmic contact material layer 105' and the active material layer 104' of the active structure material layer AS', and controlling an etching time of the wet etching process using the composite etching solution, so that the active structure material layer and the source/drain material layer can be patterned in a single wet etching process, the active structure and the source/drain electrode layer can be formed in a one-time forming manner, and the active structure as formed does not include an ohmic contact tailing and the tailing structure does not include a doping element such as phosphorus.

In some embodiments, a thickness of the active structure material layer AS' needs to be greater than a certain value so that the active layer as formed after etching has an enough thickness to meet the device performance requirements of the thin film transistor; also, the thickness of the active structure material layer (especially a thickness of the ohmic contact material layer) needs to be smaller than a certain value so that the above-mentioned composite etching solution can effectively remove a portion of the ohmic contact material layer not covered by the source/drain electrode layer (or further removing part of the active material layer) within a certain etching time, so that the active structure AS as formed does not include an ohmic contact tailing and substantially does not include a stepped structure. For example, a thickness range of the active structure material layer AS' may be from about 700 angstroms to about 1100 angstroms, or from about 800 angstroms to about 1100 angstroms, wherein a thickness t2 of the ohmic contact material layer 105' may range from about 100 angstroms to about 200 angstroms, and a thickness t1 of the active material layer 104' may range from about 600 angstroms to about 900 angstroms, but the present disclosure is not limited thereto. Compared with the embodiment of FIGs. 1A to 1D in which the source/drain electrode layer and the active structure are patterned by using a combination of wet etching and dry etching, in the present embodiment, the surface of the active structure material layer is not bombarded by plasma during the wet etching process, thus the active structure as formed has good thickness uniformity. Therefore, in this embodiment, the active structure material layer can adopt a thinner thickness than that in the embodiment of FIGs. 1A to 1D, and the active structure obtained after the wet etching can have a thickness enough to meet the device performance requirements. That is to say, using the wet etching process allows the active structure material layer to adopt a smaller thickness, which in turn enables the wet etching process to effectively remove a portion of the active structure material layer that need to be removed within a certain etching time, for example, a portion of the ohmic contact material layer that is not covered by the source/drain electrode layer can be effectively removed to eliminate the ohmic contact tailing.

In the wet etching process by using the above-mentioned composite etching solution, an etching time T includes a first etching time T1 and a second etching time T2; the first etching time T1 is the time for the first etching solution to etch the source/drain material layer; the second etching time T2 is the time for the first etching solution and the second etching solution to etch the ohmic contact material layer and/or part of the active material layer of the active structure material layer. The first etching time T1 is equal to a ratio of a thickness t3 of the source/drain material layer 105' to an etching rate a of the source/drain material layer 105' by using the composite etching solution, that is, T1 = t3/a; the second etching time T2 is equal to a ratio of a removed thickness tx of the active structure material layer AS' to an etching rate b of the active structure material layer by using the composite etching solution, that is, T2 = tx/b. In other words, T=T1+T2=t3/a+tx/b. In some embodiments, the removed thickness tx of the active structure material layer AS' may be greater than or equal to the thickness t2 of the ohmic contact material layer 105' and smaller than an overall thickness of the active structure material layer AS' (i.e., a sum of the thickness t2 of the ohmic contact material layer 105' and the thickness t1 of the active material layer 104'); that is, t2≤tx < t2+t1.

In some embodiments, on the basis that the thicknesses of the source/drain material layer 106 and the active structure material layer AS' are set in a suitable range, the etching time T should also be set in a suitable range, so that the source/drain material layer and the active structure material layer can be effectively etched by the wet etching process, the occurrence of ohmic contact tailing can be avoided, and the source/drain electrode layer and the active layer as formed have sizes enough to meet the device performance requirements. For example, the thickness t3 of the source/drain material layer 106 may range from about 3100 angstroms to 6300 angstroms, or range from 3000 angstroms to 6000 angstroms; the thickness t2 of the ohmic contact material layer 105' may range from 100 angstroms to 200 angstroms, and the thickness t1 of the active material layer 104 may range from 600 angstroms to 900 angstroms. In some embodiments, a thickness of an etched-away portion of the source/drain material layer 106 is approximately equal to the thickness t3, a thickness of an etched-away portion of the ohmic contact material layer 105' is approximately equal to the thickness t2, and a thickness of an over-etched-away portion of the active material layer 104' may range from 0 angstrom to about 200 angstroms, such as about 50 angstroms to about 200 angstroms, about 100 angstroms to about 200 angstroms, or about 100 angstroms to about 150 angstroms; a removed thickness tx of the active structure material layer AS' (i.e., a sum of the thickness t2 of the ohmic contact material layer 105' and a thickness of a removed portion of the active material layer 104') may range from about 200 angstroms to about 400 angstroms, from about 200 angstroms to about 300 angstroms, or from about 250 angstroms to about 400 angstroms. In some embodiments, the lateral etching amount L1 of the source/drain material layer 106 (i.e., the distance between the edge of the source/drain electrode layer SD as formed and the edge of the corresponding mask pattern in the direction parallel to the main surface of the base substrate 100) ranges from 0.5 micron to 0.7 micron, for example.

In some embodiments, an etching rate a of the source/drain material layer 106 (e.g., including a copper layer and/or a Mo-Nb alloy layer) by using the composite etching solution may range from about 80 angstroms per second (Å/s) to 120 Å/s. In the embodiment where the source/drain material layer 106 includes multi-layered metal materials (e.g., including a Mo-Nb alloy layer and a copper layer), the composite etching solution has substantially the same etching rate for different metal material layers; an etching rate b of the active structure material layer AS' by using the composite etching solution may range from about 15 Å/s to about 25 Å/s, wherein the composite etching solution has substantially the same etching rate for the ohmic contact material layer and the active material layer. In an example, the thickness t3 of the source/drain material layer 106 is about 3150 angstroms (for example, including a copper layer with a thickness of about 3000 angstroms and a Mo-Nb alloy layer with a thickness of about 150 angstroms), and the to-be-removed thickness tx of the active structure material layer AS' is about 300 angstroms, then the first etching time T1 ranges from about 25 seconds to 38 seconds, and the second etching time T2 ranges from about 12 seconds to 20 seconds; that is, the etching time T ranges from about 45 seconds to 58 seconds. It should be understood that the above examples are only illustrative, and the present disclosure is not limited thereto. The etching time T can be adjusted according to the specific thicknesses of the source/drain material layer 106 and the active structure material layer AS'.

Referring to FIG. 3E, after performing the wet etching process by using the composite etching solution, an active structure AS including an active layer 104 and an ohmic contact layer 105, and a source/drain electrode layer SD including a source electrode layer 106a1 and a drain electrode layer 106a2 are formed. The active layer 104 is located on a side of the gate insulating layer 103 away from the gate electrode layer 102, the source/drain electrode layer SD is located on a side of the active layer 104 away from the gate electrode 102 and the gate insulating layer 103, and the ohmic contact layer 105 is located between the active layer 104 and the corresponding source and drain electrode layers 106a1, 106a2.

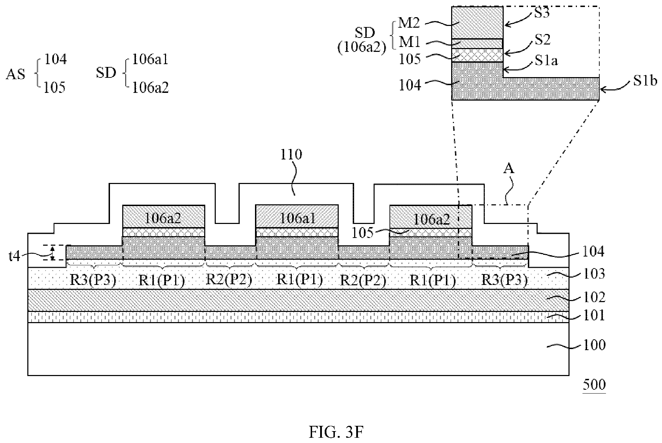

Referring to FIG. 3E and FIG. 3F, the patterned mask layer including a plurality of mask patterns 107a1 and 107a2 is then removed. For example, the patterned mask layer may be removed by a stripping process. Subsequently, an insulating layer 110 is formed over the base substrate 100 to cover the active structure AS and the source/drain electrode layer SD. A material of the insulating layer 110 includes, for example, silicon oxide, silicon nitride, silicon oxynitride or combinations thereof, and the insulating layer 110 may be formed by a deposition process such as CVD.

Referring to FIG. 3F, as such, a thin film transistor device 500 is thus formed. The thin film transistor device 500 includes a base substrate 100, a gate electrode layer 102, a gate insulating layer 103, an active structure AS, and a source/drain electrode layer SD. In some embodiments, the active structure AS includes overlapping regions R1, a channel region R2 and a tailing region R3; the overlapping region R1 of the active structure AS refers to a region where the active structure AS overlaps with the source/drain electrode layer SD in a direction perpendicular to the main surface of the base substrate 100, that is, an orthographic projection of the overlapping region R1 of the active structure AS on the base substrate in the direction perpendicular to the main surface of the base substrate 100 overlaps with an orthographic projection of the source/drain electrode layer SD on the base substrate in the direction perpendicular to the main surface of the base substrate 100. In a direction parallel to the main surface of the base substrate, the channel region R2 is located between overlapping regions R1, and the tailing region R3 is located on a side of the overlapping region R1 away from the channel region R2 and extends laterally beyond an edge of the source/drain electrode layer SD in a direction away from the channel region R2.

In some embodiments, the active layer 104 includes overlapping parts P1, a channel part P2 and a tailing part P3 which are located in the overlapping regions R1, the channel region R2 and the tailing region R3, respectively. The overlapping part P1 overlaps with the source/drain electrode layer SD in the direction perpendicular to the main surface of the base substrate 100, for example, the overlapping part P1 is located directly below the source electrode layer 106a1 or the drain electrode layer 106a2; the overlapping part P1 overlapped with the source electrode layer 106a1 and the overlapping part P1 overlapped with the drain electrode layer 106a2 are spaced apart from each other (for example, by the channel part P2) in the direction parallel to the main surface of the base substrate 100. The channel part P2 is located between adjacent overlapping parts P1, for example, between the overlapping part P1 overlapped with the source electrode layer 106a1 and the overlapping part P1 overlapped with the drain electrode layer 106a2; and the channel part P2 serves as a channel region of the thin film transistor. The tailing part P3 is a peripheral region of the active layer 104, and the tailing part P3 is located on an outer side of the overlapping part P1 (for example, the overlapping part P1 overlapped with the drain electrode layer 106a2) in the direction parallel to the main surface of the base substrate, that is, located on a side of the overlapping part P1 away from the channel part P2; the tailing part P3 extends laterally, away from the channel part P2, beyond the edges (or sidewalls) of the source/drain electrode layer SD and the ohmic contact layer 105 in a direction parallel to the main surface of the base substrate 100.

In some embodiments, the ohmic contact layer 105 is located in the overlapping region R1 of the active structure AS, and is located between the overlapping parts P1 of the active layer 104 and the source/drain electrode layer SD, that is, located between the overlapping parts P1 and the corresponding source and drain electrode layer 106a1, 106a2. The ohmic contact layer 105 may be configured to reduce a contact resistance between the source/drain electrode layer SD and the active layer 104. In some embodiments, an orthographic projection of the ohmic contact layer 105 on the main surface of the base substrate 100 in the direction perpendicular to the main surface of the base substrate 100 is within the range of an orthographic projection of the source/drain electrode layer SD on the main surface of the base substrate 100 in the direction perpendicular to the main surface of the base substrate 100. In some embodiments, the ohmic contact layer 105 is only located in the overlapping region R1 without extending into the channel region R2 and the tailing region R3. That is to say, the overlapping region R1 of the active structure AS includes the overlapping part P1 of the active layer 104, and the ohmic contact layer 105 located between the overlapping part P1 and the source/drain electrode layer SD; the channel region R2 of the active structure AS includes the channel part P2 of the active layer 104; the tailing region R3 of the active structure AS includes the tailing part P3 of the active layer 104; and neither the channel region R2 nor the tailing region R3 of the active structure AS includes the ohmic contact layer. In some embodiments, both the channel region R2 and the tailing region R3 of the active structure AS are substantially free of a doping element such as phosphorus. That is to say, the channel part P2 and the tailing part P3 of the active layer 104 are not overlapped with the ohmic contact layer 105 in the direction perpendicular to the main surface of the base substrate 100. In other words, in the direction perpendicular to the main surface of the base substrate 100, orthographic projections of the channel part P2 and the tailing part P3 of the active layer 104 on the main surface of the base substrate 100 are not overlapped with and are offset from the orthographic projection of the ohmic contact layer 105 on the main surface of the base substrate 100.

Referring to FIG. 3F and the enlarged view of area A, in some embodiments, the ohmic contact layer 105 does not extend beyond the edge of the source/drain electrode layer SD (i.e., the corresponding source electrode layer 106a1 and drain electrode layer 106a2). For example, the edge (or sidewall) S2 of the ohmic contact layer 105 is substantially aligned with the edge (or sidewall) S3 of the source/drain electrode layer SD (for example, in the direction perpendicular to the main surface of the base substrate 100). It should be understood that, although the sidewalls of the source/drain electrode layer SD and the ohmic contact layer 105 are illustrated to be straight (for example, substantially perpendicular to the main surface of the base substrate) in the figures, and the corresponding sidewalls of the source/drain electrode layer SD and the ohmic contact layer in this embodiment are aligned in the direction substantially perpendicular to the main surface of the base substrate, the present disclosure is not limited thereto. In some embodiments, the sidewalls of the source/drain electrode layer SD and the ohmic contact layer 105 may also be inclined; in such embodiment, the edge of the source/drain electrode layer SD being aligned with the edge of the ohmic contact layer 105 may include the case where the sidewall of the source/drain electrode layer SD and the sidewall of the ohmic contact layer 105 are in the same plane, in which the plane may be substantially perpendicular to the main surface of the base substrate, or, the plane may not be perpendicular to the main surface of the base substrate but may have, for example, a non-right angle with respect to the main surface of the base substrate.

In some embodiments, in the above etching process, part of the active material layer is removed by over-etching, so that a thickness t4 of the channel part P2 and of the tailing part P3 of the active layer 104 is smaller than the thickness t1 of the overlapping part P1, but the present disclosure is not limited to this. In some other embodiments in which the active material layer is not removed substantially by the above etching process, the thickness t4 of the channel part P2 and of the tailing part P3 may be approximately equal to the thickness t1 of the overlapping part P1. In the embodiment in which the thickness t4 is smaller than the thickness t1, the overlapping part P1 of the active layer 104 protrudes from the surfaces of the channel part P2 and of the tailing part P3 at the side away from the gate insulating layer 103, and towards the source/drain electrode layer SD in the direction perpendicular to the main surface of the base substrate 100. In some embodiments, the edge (or sidewall) S1a of a portion of the overlapping part P1 of the active layer 104 that protrudes from the channel part P2 and the tailing part P3 is substantially aligned with the edge (or sidewall) S2 of the corresponding ohmic contact layer 105 and the edge (or sidewall) S3 of the source/drain electrode layer SD, for example, in a direction perpendicular to the main surface of the base substrate 100. That is to say, in the direction perpendicular to the main surface of the base substrate 100, an orthographic projection of a portion of the active layer 104 with a relatively large thickness (for example, the overlapping part P1) on the main surface of the base substrate 100 overlaps with orthographic projections of the ohmic contact layer 105 and the source/drain electrode layer SD on the main surface of the base substrate 100, and is located within a range of the orthographic projection of the source/drain electrode layer SD on the main surface of the base substrate 100, for example.

The tailing part P3 of the active layer 104 laterally protrudes from the ohmic contact layer 105 and the source/drain electrode layer SD, and away from the channel part P2 in the direction parallel to the main surface of the base substrate 100, that is, extending beyond the edge S2 of the ohmic contact layer 105 and the edge S3 of the source/drain electrode layer SD; and the surface of the tailing part P3 at the side away from the gate electrode 102 and the gate insulating layer 103 is not covered by the ohmic contact layer 105 and not in contact with the ohmic contact layer 105. In some embodiments, the edge (or sidewall) S1b of the tailing part P3 and the edge (or sidewall S1a) of the overlapping part P1 are offset from each other in a direction parallel to the main surface of the base substrate 100; and the edge S1b of the tailing part P3 is closer to the edge of the base substrate 100 than the edge S1a of the overlapping part P1. In some embodiments, the tailing part P3 has a substantially uniform thickness without a stepped structure. In some embodiments, both the tailing region R3 and the channel region R2 of the active structure AS do not include a stepped structure, and do not include an ohmic contact layer tailing, and substantially do not include a doping element such as group IIIA doping element (e.g., boron) or group VA doping element (e.g., phosphorus).

In some embodiments, since the ohmic contact layer 105 does not extend into the channel region R2, the channel part P2 of the active layer 104 is not covered by the ohmic contact layer 105, and the surface of the channel part P2 at the side away from the gate electrode 102 and the gate insulating layer 103 is not in contact with the ohmic contact layer 105. In some embodiments, at least the channel part P2 and the tailing part P3 of the active layer 104 have a substantially uniform thickness; that is, the thickness t4 of the channel part P2 is substantially equal to the thickness t4 of the tailing part P3. In some embodiments, the thickness uniformity of the thickness T4 of the channel part P2 and the tailing part P3 of the active layer 104 may range from 5% to 12%, for example, may be smaller than 10%, for example, may be 7.3% to 7.7%. By way of example, in the entire active layer 104, the thicknesses t4 of various parts of the channel part P2 and of the tailing part P3 may be slightly different, and have a maximum thickness value tₘₐₓ and a minimum thickness value tₘᵢₙ. Here, the thickness uniformity of the thickness t4 of the active layer 104 refers to: (the maximum thickness value of the thickness T4 minus the minimum thickness value of the thickness T4) / (the maximum thickness value of the thickness T4 plus the minimum thickness value of the thickness T4), which is equal to (tₘₐₓ-tₘᵢₙ) / (tₘₐₓ+tₘᵢₙ). In some embodiments, the thickness t4 of the channel part P2 and of the tailing part P3 of the active layer 104 is approximately equal to the thickness t1 of the overlapping part P1, the entire active layer 104 has an approximately uniform thickness, and the thickness uniformity of the active layer 104 is within the above range.

In some embodiments, the source/drain electrode layer SD includes multi-layered metal materials, for example, a first metal layer M1 and a second metal layer M2, and the first metal layer M1 is located between the ohmic contact layer 105 and the second metal layer M2. The first metal layer M1 is, for example, a Mo-Nb alloy layer, and the second metal layer M2 is, for example, a copper layer. In some embodiments, in the wet etching process by using the composite etching solution, lateral etching amounts of the first metal layer and of the second metal layer are approximately the same, so that an edge of the first metal layer M1 as formed and an edge of the second metal layer M2 as formed are approximately aligned, for example, in the direction perpendicular to the main surface of the base substrate 100. In some embodiments, an orthographic projection of the second metal layer M2 on the main surface of the base substrate 100 in the direction perpendicular to the main surface of the base substrate 100 is within the range of an orthographic projection of the first metal layer M1 on the main surface of the base substrate 100 in the direction perpendicular to the main surface of the base substrate 100.

In some embodiments, the insulating layer 110 is located on a side of the gate insulating layer 103 away from the gate electrode 102, and covers the active structure AS and the source/drain electrode layer SD. By way of example, the insulating layer 110 covers and contacts the sidewall of the tailing part P3 of the active layer 104 and its surface away from the gate insulating layer 103, the sidewall of the overlapping part P1 of the active layer 104, the surface of the channel part P2 of the active layer 104 away from the gate insulating layer 103, the sidewall of the ohmic contact layer 105, and the sidewall of the source/drain electrode layer SD and its surface away from the active structure AS. In this embodiment, since the ohmic contact layer 105 does not have an ohmic contact layer tailing that protrudes laterally beyond the source/drain electrode layer SD, the surface of the ohmic contact layer 105 at the side away from the active layer 104 in the direction perpendicular to the main surface of the base substrate 100 is not in contact with the insulating layer 110. By way of example, the ohmic contact layer 105 has a sidewall in contact with the insulating layer 110 and has an end part close to this sidewall, and a surface of the end part of the ohmic contact layer 105 away from the active layer 104 is covered by the source/drain electrode layer SD and separated from the insulating layer 110. On the other hand, since the ohmic contact layer 105 does not have an ohmic contact layer tailing, and since the channel part P2 of the active layer 104 is not covered by the ohmic contact layer, the surface of the channel part P2 of the active layer 104 at the side away from the gate electrode 102 and the gate insulating layer 103 is covered by and in contact with the insulating layer 110. In some embodiments, a contact area between, the surface of the channel part P2 of the active layer 104 at the side away from the gate electrode 102 and the gate insulating layer 103, and the insulating layer 110, is approximately equal to an area of the surface of the channel part P2 at the side away from the gate electrode 102 and the gate insulating layer 103. A contact area between, the surface of the tailing part P3 of the active layer 104 at the side away from the gate electrode 102 and the gate insulating layer 103, and the insulating layer 110, is approximately equal to an area of the surface of the tailing part P3 at the side away from the gate electrode 102 and the gate insulating layer 103. That is, a contact area between, the surface of the channel part P2 and the tailing part P3 of the active layer 104 at the side away from the gate insulating layer 103, and the insulating layer 110, is approximately equal to an area of the surface of the channel part P2 and the tailing part P3 at the side away from the gate insulating layer 103.

In order to understand the wet etching process performed on the source/drain material layer and the active structure material layer by using the composite etching solution in the present disclosure in a better way, the present disclosure will be further elaborated as below through embodiments and comparative examples. However, it should be understood that the following examples are only illustrative and the present disclosure is not limited thereto.

In some examples, the composite etching solution is prepared by using the components illustrated in Table 1 as below.

**[Table 1]**

| | first etching solution (hydrogen peroxide) | second etching solution (fluoride) | metal chelating agent (amino compound) | hydrogen peroxide stabilizer (organic acid compound) | slope angle regulator (inorganic acid compound) | water |
|---|---|---|---|---|---|---|
| Embodiment 1 | 22% | 0.2% | 3% | 1.5% | 0.3% | margin |
| Embodiment 2 | 21% | 0.25% | 2.5% | 2% | 0.35% | margin |
| Embodiment 3 | 20% | 0.3% | 2% | 2.5% | 0.4% | margin |
| Embodiment 4 | 21% | 0.15% | 3% | 1.5% | 0.3% | margin |
| Embodiment 5 | 20% | 0.4% | 3% | 1.5% | 0.3% | margin |
| Comparative Example 1 | 22% | 0.5% | 2% | 2.5% | 0.4% | margin |
| Comparative Example 2 | 22% | 0.05% | 3% | 2.5% | 0.4% | margin |
| Fluoride: ammonium bifluoride; | | | | | | |
| Amino compounds: glycine, alanine or iminodiacetic acid; | | | | | | |
| Organic acid compounds: iminodiacetic acid; | | | | | | |
| Inorganic acid compounds: ammonium sulfate; | | | | | | |
| The above numerical values indicate mass fractions of the corresponding components in the composite etching solution, and a mass fraction of fluoride refers to a mass fraction of fluoride ions dissociated in the etching solution. | | | | | | |

Based on the component contents in Table 1 above, the required mass of each of the raw materials can be calculated, then hydrogen peroxide, fluoride, amino compound, organic acid compound and inorganic acid compound are added sequentially into ultrapure water with corresponding mass, and are mixed evenly, so as to prepare the composite etching solutions used for the respective embodiments and comparative examples.

Wet etching processes are respectively performed on the source/drain material layer (including a copper layer and a Mo-Nb alloy layer), the ohmic contact material layer (phosphorus-doped amorphous silicon layer) and part of the active material layer (amorphous silicon layer) by using the composite etching solutions of the above Embodiments 1-5 and Comparative Examples 1-2 under experiment conditions of spraying at 33°C. The thicknesses and related etching parameters for respective layers in the embodiments and comparative examples are illustrated in Table 2 as below, and evaluation results of the etching are illustrated in Table 3 as below.

**[Table 2]**

| | thickness (t3) of source/drain material layer | thickness (t1+t2) of active structure material layer | etched thickness (tx) of active structure material layer | etching time T(T1+T2) | etching rate (a) | etching rate (b) | etchin g ratio (a/b) | Lateral etching amount (L1) |
|---|---|---|---|---|---|---|---|---|
| Embodiment 1 | 3150Å (3000/150) | 1000Å (850/150) | 300Å | 55s (30/25) | 105.0Å/s | 12Å/s | 8.8 | 0.5-0.6 µm |
| Embodiment 2 | 3150Å (3000/150) | 1000Å (850/150) | 300Å | 54s (32/22) | 98.4Å/s | 13.6Å/s | 7.2 | 0.5-0.6 µm |
| Embodiment 3 | 3150Å (3000/150) | 1000Å (850/150) | 300Å | 55s (35/20) | 90.0Å/s | 15Å/s | 6.0 | 0.5-0.6 µm |
| Embodiment 4 | 3150 Å (3000/150) | 1000Å (850/150) | 300Å | 63 (33/30) | 101.6Å/s | 9.4Å/s | 108 | 0.7-0.8 µm |
| Embodiment 5 | 3150 Å (3000/150) | 1000Å (850/150) | 300Å | 53 (36/17) | 87.5 Å/s | 15Å/s | 5.0 | 0.5-0.6 µm |
| Comparative example1 | 3150Å (3000/150) | 1000Å (850/150) | 300Å | 51s (37/15) | 85.1 Å/s | 20Å/s | 4.3 | 0.5-0.6 µm |
| Comparative example2 | 3150Å (3000/150) | 1000Å (850/150) | 16Å | 55s (29/26) | 108.6Å/s | 0.6Å/s | 181 | 0.5-0.6 µm |

**[Table 3]**

| | uniformity of thickness t4 of active layer | whether there is ohmic contact layer tailing in tailing region and channel region. | whether there is stepped structure in tailing region and channel region | whether there is undercut in source/drain electrode layer |
|---|---|---|---|---|
| Embodiment 1 | 7.5% | No | No | No |
| Embodiment 2 | 7.7% | No | No | No |
| Embodiment 3 | 7.3% | No | No | No |
| Embodiment 4 | 7.4% | No | No | No |
| Embodiment 5 | 7.3% | No | No | No |
| Comparative eample1 | 7.7% | No | No | Yes |
| Comparative example2 | 7.6% | Yes | No | No |

In Table 2 above, the thickness t3 of the source/drain material layer is approximately equal to the thickness of the source/drain material layer that is removed by etching; the source/drain material layer includes a copper layer, and a Mo-Nb alloy layer located between the copper layer and the ohmic contact material layer; among the numerical values corresponding to the thickness t3 in Table 1, the number before the bracket represent the sum of thicknesses of the copper layer and the Mo-Nb alloy layer, and the numbers in the bracket respectively represent the thicknesses of the copper layer and the Mo-Nb alloy layer. For example, in Embodiment 1, 3150Å (3000/150) indicates that the overall thickness t3 of the source/drain material layer is 3150 angstroms, in which the thickness of the Mo-Nb alloy layer is 150 angstroms and the thickness of the copper layer is 3000 angstroms. The thickness of the active structure material layer is the sum of the thickness t1 of the active material layer and the thickness t2 of the ohmic contact material layer; and the corresponding number before the bracket in Table 2 indicate the sum of the thickness t1 and the thickness t2, and the numbers in the bracket respectively indicate the values of the thickness t1 and the thickness t2. For example, in Embodiment 1, 1000Å (850/150) indicates that the sum of the thickness t1 of the active material layer and the thickness t2 of the ohmic contact material layer is 1000 Å, in which the value of the thickness t1 of the active material layer is 850 Å, and the value of the thickness t2 of the ohmic contact material layer is 150 Å. The etched thickness tx of the active structure material layer represents the sum of the thickness t2 of the ohmic contact material layer removed by etching and the thickness of the active material layer removed by over-etching. The etching time T is the sum of the first etching time T1 for etching the source/drain material layer and the second etching time T2 for etching the active structure material layer, in which the numbers before the brackets indicate the values of the etching time T, and the numbers in the brackets indicate the values of the first etching time T1 and the second etching time T2 respectively. For example, 55s (30/25) in Embodiment 1 indicates that the etching time T is 55s, in which the first etching time T1 for etching the source/drain material layer is 30s and the second etching time T2 for etching the active structure material layer is 25s. The etching rate a is an overall etching rate of etching the source/drain material layer by the composite etching solution; the etching rate b is an overall etching rate of etching the active structure material layer by the composite etching solution; the etching ratio a/b is an etching selectivity ratio of etching the source/drain material layer to etching the active structure material layer by the composite etching solution; the lateral etching amount L1 is a width of a portion of the source/drain material layer laterally recessed from the edge of the mask layer in the direction parallel to the main surface of the base substrate when the source/drain material layer is etched by the composite etching solution, that is, a distance between the edge of the source/drain electrode layer as formed and the edge of the mask layer in the direction parallel to the main surface of the base substrate; the uniformity of the active layer refers to the uniformity of the thickness of the channel part and the tailing part of the active layer as formed after the etching process using the composite etching solution, wherein the thickness refers to a thickness in the direction perpendicular to an extension direction of the active layer, for example, the thickness in the direction perpendicular to the main surface of the base substrate.

According to Table 1 to Table 3, in the etching process using the composite etching solution, the etching rate of etching the source/drain material layer is approximately proportional to the content of the first etching solution, that is, the etching rate of the source/drain material layer increases with the increase of the content of the first etching solution or decreases with the decrease of the content of the first etching solution; the etching rate of etching the active structure material layer is approximately proportional to the content of the second etching solution, that is, the etching rate of the active structure material layer increases with the increase of the content of the second etching solution or decreases with the decrease of the content of the second etching solution. In Embodiments 1 to 5, the component contents of the composite etching solutions are within the aforementioned content ranges, so that the to-be-removed portions of the source/drain material layer and the active structure material layer can be effectively etched by the wet etching process using the composite etching solution, and the source/drain material layer and the active structure material layer can be patterned into the source/drain electrode layer and the active structure in a single wet etching process, and the source/drain electrode layer and the active layer as formed have enough sizes to meet the device performance requirements, and the tailing region and the channel region of the active structure do not include an ohmic contact layer tailing or a stepped structure, and the active layer has satisfied thickness uniformity.

In Embodiments 1-5, the etching rates of etching the copper layer and etching the Mo-Nb alloy layer of the source/drain material layer are substantially the same. Although the increase of the content of fluorine ions may affect the etching rate of the source/drain material layer, the fluorine ions with a content in a suitable range will have little influence on the etching rate of the source/drain material layer and will substantially not cause much difference between the etching rates of the copper layer and the Mo-Nb alloy layer; as a result, the etching rates of etching the copper layer and etching the Mo-Nb alloy layer are substantially the same, such that the lateral etching amounts of the copper layer and the Mo-Nb alloy layer are substantially the same, without generating an undercut in the source/drain electrode layer as formed.

In Comparative Example 1, a mass fraction of fluoride ions dissociated from the fluoride in the composite etching solution as used is 0.5%, which exceeds the abovementioned range (0.1% to 0.4%) of mass fraction of fluoride ions. In this example, the mass fraction of fluorine ions increases, which leads to an undercut occurring in the Mo-Nb alloy layer. This is because the excessively large content of fluoride ions has obvious influence on the etching rates of etching the copper layer and etching the Mo-Nb alloy layer; for example, the etching rate of etching the Mo-Nb alloy layer is obviously accelerated and the etching rate of etching the copper layer is obviously reduced, as a result, the etching rate of etching the Mo-Nb alloy layer is higher than that of etching the copper layer, and then the lateral etching amount of the Mo-Nb alloy layer is greater than that of the copper layer, thus rendering an undercut in the Mo-Nb alloy layer. It should be understood that the lateral etching amount L1 of Comparative Example 1 in Table 2 mainly refers to the lateral etching amount of the copper layer, and the lateral etching amount of the Mo-Nb alloy layer in Comparative Example 1 is greater than the value illustrated in Table 2; moreover, in the source/drain material layer, because the Mo-Nb alloy layer has a smaller thickness, and the copper layer has a much greater thickness than the Mo-Nb alloy layer, the overall etching rate of the source/drain material layer depends more on the etching rate of the copper layer, while the etching rate of the Mo-Nb alloy layer has little influence on the overall etching rate of the source/drain material layer. For example, the increase of the etching rate of etching the Mo-Nb alloy layer will not significantly increase the overall etching rate of the source/drain material layer.

In Comparative Example 2, the mass fraction of fluorine ion is 0.05%, which is smaller than the above-mentioned content range of fluorine ions in the embodiment of the present disclosure. In this example, the excessively low content of fluorine ions results in an excessively low etching rate of the active structure material layer, and in a certain etching time, the etching amount of the active structure material layer is too small to effectively etch the ohmic contact material layer in the active structure material layer; moreover, in this example, if the etching time is greatly increased (for example, more than 250s) in order to remove the ohmic contact material layer, the lateral etching amount of the source/drain material layer will also be considerably increased, which makes it impossible to ensure that the source/drain electrode layer as formed has a size enough to meet the device performance requirements.

Compared with the Comparative Example 1 and the Comparative Example 2, the component contents of the composite etching solutions in Embodiments 1-5 are respectively set in appropriate ranges, so that the source/drain material layer and the active structure material layer can be effectively etched in a single wet etching process, and the problems such as the ohmic contact tailing and the stepped structure in the tailing region and channel region of the active structure, as well as the problem of undercut in the source/drain electrode layer, can be avoided.

In the above embodiments, the concept of the present disclosure has been explained with reference to the cases where the composite etching solution includes a first etching solution and a second etching solution mixed with each other, and the source/drain material layer and the active structure material layer are patterned by a single wet etching process by way of example, but the present disclosure is not limited thereto. It should be understood that those skilled in the art can modify or change the above-mentioned embodiments without violating the concept of the present disclosure, such as slightly adjusting the film layer thicknesses of the source/drain material layer, the ohmic contact material layer and/or the active material layer, and slightly adjusting the contents of hydrogen peroxide and fluoride in the composite etching solution, which can still achieve the same or similar technical effects as the embodiments in the present disclosure. Alternatively, the first etching solution and the second etching solution of the composite etching solution in the present disclosure can be used as two separate etching solutions for etching the source/drain material layer and the active structure material layer (including the ohmic contact material layer and/or part of the active material layer), respectively, in two wet etching steps; that is, a first wet etching process is performed by using the first etching solution including hydrogen peroxide to etch the source/drain material layer and oxidize a portion of the active structure material layer, and then a second wet etching process is performed by using the second etching solution including fluoride to etch the oxidized portion of the active structure material layer. The above-mentioned etching method is also included in the scope of the present disclosure, and can also achieve technical effects similar or closer to that of the above embodiments of the present disclosure. Therefore, modifications and changes made without departing from the basic principles of the concept of the present disclosure all should be included within the protection scope of the present disclosure. It should be understood that the preferred embodiment of the present disclosure is to perform a single wet etching process to pattern the source/drain material layer and the active structure material layer by using the first etching solution and the second etching solution mixed with each other, which can increase the etching efficiency and hence improve the production efficiency.

It should be understood that the above embodiments illustrate the present disclosure with reference to the case where the thin film transistor device is applied in an array substrate of a display device such as LCD by way of example. However, the present disclosure is not limited to this, and the above-described thin film transistor device and the manufacturing method thereof as well as the composite etching solution can also be applied to other types of devices and their manufacturing methods.

In some embodiments of the present disclosure, the source/drain material layer and the active structure material layer are patterned into a source/drain electrode layer and an active structure in a wet etching process by using a composite etching solution including a first etching solution and a second etching solution mixed with each other. Compared with the use of combination of a wet etching process and a dry etching process to pattern the source/drain material layer and the active structure material layer illustrated in FIGs. 1A to 1C, the above-described embodiments of the present disclosure uses a composite etching solution for wet etching, which omits the processes of patterning the active structure material layer by dry etching, reduces the use of toxic gases such as chlorine gas, improves the production safety and efficiency, and lowers the production cost.

On the other hand, in the active structure formed by a wet etching with the use of the composite etching solution, the ohmic contact layer tailing and the stepped structure are eliminated from the tailing region and the channel region of the active structure, and the tailing region and the channel region of the active structure substantially do not contain a doping element such as group IIIA doping element or group VA doping element (such as phosphorus), so that the adverse influence on the thin film transistor device caused by ohmic contact layer tailing can be avoided, for example, the off-state leakage current and static electricity-related defective rate of the thin film transistor device can be reduced, and the device performance of the thin film transistor device can be further improved. Furthermore, by adopting the wet etching process, it can avoid plasma used in a dry etching from bombarding film layers of the active structure, and hence avoid the adverse influence on the film layers and the device performances caused by plasma bombardment, thereby improving the device performance. Moreover, compared with the dry etching process, the wet etching process allows the active layer as formed to have satisfied thickness uniformity; and in the embodiment of the present disclosure, it also includes adjusting the thickness of the active structure material layer, for example, by using a thinner active structure material layer, so as to lower the cost for film formation, and also to achieve a smaller size (for example, thickness) of the tailing region of the active structure as formed, thereby preventing from any adverse influence on the device performances due to a larger-sized tailing region; for example, by decreasing the size of the tailing region, the off-state leakage current and static electricity-related defective rate of the thin film transistor device can be reduced and the device performances can be improved.

The following statements should be noted: (1) the accompanying drawings related to the embodiment(s) of the present disclosure involve only the structure(s) in connection with the embodiment(s) of the present disclosure, and other structure(s) can be referred to common design(s); (2) in case of no conflict, features in one embodiment or in different embodiments of the present disclosure can be combined.

The above, are only specific embodiments of the present disclosure, but the scope of protection of the present disclosure is not limited thereto, and any variation or substitution readily conceivable by any person skilled in the art within the technical scope disclosed in the present disclosure shall be covered by the scope of protection of the present disclosure. Accordingly, the scope of protection of the present disclosure shall be defined by the scope of protection of the claims.

## Claims

1. A method of manufacturing a thin film transistor device, comprising:
forming a gate electrode layer on a base substrate;
forming a gate insulating layer on a side of the gate electrode layer;
forming an active structure material layer on a side of the gate insulating layer away from the gate electrode layer, wherein the active structure material layer comprises an active material layer and an ohmic contact material layer, and the ohmic contact material layer is formed on a side of the active material layer away from the gate insulating layer;
forming a source/drain material layer on a side of the active structure material layer away from the gate insulating layer; and
performing a wet etching process on the source/drain material layer and the active structure material layer by using a patterned mask layer as an etching mask and using a composite etching solution, so as to pattern the source/drain material layer and the active structure material layer into a source/drain electrode layer and an active structure, wherein the composite etching solution comprises a first etching solution and a second etching solution, and the wet etching process comprises: etching the source/drain material layer and oxidizing a portion of the active structure material layer through the first etching solution, and etching an oxidized portion of the active structure material layer through the second etching solution,
wherein the active structure comprises an active layer and an ohmic contact layer, and the active structure has overlapping regions, a channel region and a tailing region, wherein the overlapping regions overlap with the source/drain electrode layer in a direction perpendicular to a main surface of the base substrate, the channel region is located between the overlapping regions, and the tailing region laterally extends beyond an edge of the source/drain electrode layer away from the channel region in a direction parallel to the main surface of the base substrate; wherein the ohmic contact layer is located in the overlapping regions, and in the direction perpendicular to the main surface of the base substrate, an orthographic projection of the ohmic contact layer on the base substrate is located within a range of an orthographic projection of the source/drain electrode layer on the base substrate.

2. The method of manufacturing the thin film transistor device according to claim 1, wherein the overlapping regions of the active structure comprises an overlapping part of the active layer, and the ohmic contact layer located between the overlapping part and the source/drain electrode layer; the channel region comprises a channel part of the active layer, the tailing region comprises a tailing part of the active layer, and neither the channel region nor the tailing region comprises the ohmic contact layer.

3. The method of manufacturing the thin film transistor device according to claim 2, wherein an edge of the ohmic contact layer and an edge of the source/drain electrode layer are substantially aligned in the direction perpendicular to the main surface of the base substrate.

4. The method of manufacturing the thin film transistor device according to claim 3, wherein a thickness of the overlapping part of the active layer is greater than a thickness of the channel part and a thickness of the tailing part of the active layer; and the overlapping part of the active layer has an edge substantially aligned with the edge of the ohmic contact layer and the edge of the source/drain electrode layer in the direction perpendicular to the main surface of the base substrate.

5. The method of manufacturing the thin film transistor device according to claim 2, wherein a thickness uniformity of the channel part and the tailing part of the active layer ranges from 5% to 12%.

6. The method of manufacturing the thin film transistor device according to claim 2, wherein the tailing part of the active layer is free of a stepped structure.

7. The method of manufacturing the thin film transistor device according to claim 1, wherein the source/drain material layer comprises a metal material, the active layer comprises a semiconductor material, and the ohmic contact layer comprises a doped semiconductor material and has a group IIIA doping element or a group VA doping element.

8. The method of manufacturing the thin film transistor device according to claim 7, wherein the tailing region of the active structure is free of a group IIIA doping element or a group VA doping element.

9. The method of manufacturing the thin film transistor device according to claim 1, wherein the first etching solution comprises hydrogen peroxide, and the second etching solution comprises fluoride.

10. The method of manufacturing the thin film transistor device according to claim 9, wherein among the composite etching solution, a mass fraction of fluoride ions dissociated from the fluoride in the composite etching solution ranges from 0.1% to 0.4%.

11. The method of manufacturing the thin film transistor device according to claim 10, wherein a mass fraction of the hydrogen peroxide in the composite etching solution ranges from 15% to 25%.

12. The method of manufacturing the thin film transistor device according to any one of claims 1-11, wherein a thickness of the ohmic contact material layer ranges from 100 angstroms to 200 angstroms.

13. The method of manufacturing the thin film transistor device according to claim 12, wherein a thickness of the active material layer ranges from 600 angstroms to 900 angstroms.

14. The method of manufacturing the thin film transistor device according to claim 13, wherein a thickness of a portion of the active structure material layer removed by the wet etching process ranges from 200 angstroms to 400 angstroms.

15. The method of manufacturing the thin film transistor device according to claim 1, wherein the first etching solution and the second etching solution in the composite etching solution are mixed with each other, and the source/drain material layer and the active structure material layer are etched in a single wet etching process.

16. The method of manufacturing the thin film transistor device according to claim 1, wherein the patterned mask layer comprises a plurality of mask patterns spaced apart from each other, and a surface of the source/drain material layer away from the active structure material layer is partially exposed before the wet etching process is performed, and an edge of the source/drain material layer laterally extends beyond an edge of the patterned mask layer in the direction parallel to the main surface of the base substrate.

17. The method of manufacturing the thin film transistor device according to claim 16, wherein before the wet etching process, further comprising:
forming an initial mask layer on a side of the source/drain material layer away from the active structure material layer, wherein the initial mask layer comprises a first mask pattern region and a second mask pattern region, and a thickness of the first mask pattern region is greater than a thickness of the second mask pattern region.

18. The method of manufacturing the thin film transistor device according to claim 17, further comprising:
performing an initial wet etching process on the source/drain material layer by using the initial mask layer as an etching mask;
performing an ashing process on the initial mask layer to remove the second mask pattern region of the initial mask layer and reduce a size of the first mask pattern region, wherein a remaining portion of the first mask pattern region forms the patterned mask layer; and
performing a dry etching process on the active structure material layer by using the patterned mask layer and the source/drain material layer as an etching mask, after the initial wet etching process and before the wet etching process using the composite etching solution.

19. The method of manufacturing the thin film transistor device according to claim 2, wherein after performing the wet etching process, further comprising:
removing the patterned mask layer; and
forming an insulating layer to cover sidewalls of the source/drain electrode layer and the active structure layer as well as surfaces thereof away from the gate insulating layer,
wherein surfaces of the channel part and the tailing part of the active layer away from the gate insulating layer are in contact with the insulating layer; and a contact area between the insulating layer and the channel part and between the insulating layer and the tailing part, is substantially equal to an area of the surfaces of the channel part and the tailing part away from the gate insulating layer.

20. A composite etching solution for forming a thin film transistor device, comprising:
a first etching solution and a second etching solution, wherein the first etching solution comprises hydrogen peroxide and the second etching solution comprises fluoride, the first etching solution is configured to etch a source/drain material layer to form a source/drain electrode layer of a thin film transistor and oxidize an active structure material layer, and the second etching solution is configured to etch an oxidized part of the active structure material layer to form an active structure of the thin film transistor; and
a hydrogen peroxide stabilizer and a metal chelating agent,
wherein in the composite etching solution, a mass fraction of fluoride ions dissociated from the fluoride ranges from 0.1% to 0.4%.

21. The composite etching solution for forming a thin film transistor device according to claim 20, wherein a mass fraction of the hydrogen peroxide ranges from 15% to 25%.

22. The composite etching solution for forming a thin film transistor device according to claim 20, wherein the fluoride comprises at least one selected from a group consisted of hydrofluoric acid and hydrofluride.

23. The composite etching solution for forming a thin film transistor device according to claim 20, wherein the hydrogen peroxide stabilizer is selected from organic acid compounds, and the metal chelating agent is at least one selected from a group consisted of glycine, alanine and iminodiacetic acid.

24. The composite etching solution for forming a thin film transistor device according to claim 23, wherein the first etching solution is configured to react with a metal of the source/drain material layer to generate metal ions, and the metal chelating agent is configured to chelate the metal ions.

25. The composite etching solution for forming a thin film transistor device according to claim 23, wherein in the composite etching solution, a mass fraction of the hydrogen peroxide stabilizer ranges from 1.5% to 4%, and a mass fraction of the metal chelating agent ranges from 1% to 3%.

26. The composite etching solution for forming a thin film transistor device according to claim 20, further comprising a slope angle regulator, and the slope angle regulator is selected from inorganic acid compounds.

27. A thin film transistor device, comprising:
a gate electrode layer, located on a base substrate;
a gate insulating layer, located on a side of the gate electrode layer;
an active structure, located on a side of the gate insulating layer away from the gate electrode layer; and
a source/drain electrode layer, located on a side of the active structure away from the gate insulating layer,
wherein the active structure comprises an active layer, and an ohmic contact layer located between the active layer and the source/drain electrode layer, and the active structure has overlapping regions, a channel region and a tailing region; the overlapping regions overlap with the source/drain electrode layer in a direction perpendicular to a main surface of the base substrate, the channel region is located between the overlapping regions, and the tailing region laterally extends beyond an edge of the source/drain electrode layer away from the channel region in a direction parallel to the main surface of the base substrate; wherein the ohmic contact layer is located in the overlapping regions, and in the direction perpendicular to the main surface of the base substrate, an orthographic projection of the ohmic contact layer on the base substrate is located within a range of an orthographic projection of the source/drain electrode layer on the base substrate.

28. The thin film transistor device according to claim 27, wherein the ohmic contact layer does not extend into the channel region and the tailing region.

29. The thin film transistor device according to claim 28, wherein the active layer comprises an overlapping part, a channel part and a tailing part located in the overlapping regions, the channel region and the tailing region, respectively, and the ohmic contact layer is located between the overlapping part of the active structure and the source/drain electrode layer.

30. The thin film transistor device according to claim 29, wherein the active layer comprises a semiconductor material, the ohmic contact layer comprises a doped semiconductor material doped with a group IIIA doping element or a group VA doping element, and the tailing region of the active structure does not comprise a group IIIA doping element or a group VA doping element.

31. The thin film transistor device according to claim 30, wherein the channel region of the active structure does not comprise a group IIIA doping element or a group VA doping element, either.

32. The thin film transistor device according to claim 29, wherein an edge of the ohmic contact layer and an edge of the source/drain electrode layer are substantially aligned in the direction perpendicular to the main surface of the base substrate.

33. The thin film transistor device according to claim 32, wherein a thickness of the overlapping part of the active layer is greater than a thickness of the channel part and a thickness of the tailing part of the active layer, and the overlapping part of the active layer has an edge substantially aligned with the edge of the ohmic contact layer and the edge of the source/drain electrode layer in the direction perpendicular to the main surface of the base substrate.

34. The thin film transistor device according to claim 29, wherein a thickness of the channel part and a thickness of the tailing part of the active layer are smaller than or equal to a thickness of the overlapping part.

35. The thin film transistor device according to claim 34, wherein a thickness uniformity of the channel part and the tailing part of the active layer ranges from 5% to 12%.

36. The thin film transistor device according to claim 29, further comprising:
an insulating layer, located above the base substrate and covering the source/drain electrode layer and the active structure,
wherein the ohmic contact layer has a sidewall in contact with the insulating layer and an end part close to the sidewall, and a surface of the end part of the ohmic contact layer away from the active layer is covered by the source/drain electrode layer and is separated from the insulating layer.

37. The thin film transistor device according to claim 36, wherein surfaces of the channel part and the tailing part of the active layer away from the gate insulating layer are in contact with the insulating layer; and a contact area between the insulating layer and the channel part and between the insulating layer and the tailing part is substantially equal to an area of the surfaces of the channel part and the tailing part away from the gate insulating layer.

38. The thin film transistor device according to claim 29, wherein a thickness of the overlapping part of the active layer ranges from 600 angstroms to 900 angstroms.

39. The thin film transistor device according to any one of claims 27-38, wherein a thickness of the ohmic contact layer ranges from 100 angstroms to 200 angstroms.

40. An array substrate, comprising the thin film transistor device according to any one of claims 27-39.
